# EUROPEAN PATENT APPLICATION

(11) **EP 4 651 666 A1**
(43) Date of publication of application: **19.11.2025**
(21) Application number: 25171579.3
(22) Date of filing: 22.04.2025
(51) Int. Cl.: H10B 41/10, H10B 41/50, H10B 43/10, H10B 43/50, H01L 23/528

(54) **SEMICONDUCTOR DEVICES AND DATA STORAGE SYSTEMS INCLUDING THE SAME**

(30) Priority: 16.05.2024 KR 20240063881
(71) Applicant: Samsung Electronics Co., Ltd., Suwon-si, Gyeonggi-do 16677 (KR)
(72) Inventor: JEON, Wooyong, 16677 Suwon-si, Gyeonggi-do (KR); KIM, Jiyoung, 16677 Suwon-si, Gyeonggi-do (KR); CHO, Wonseok, 16677 Suwon-si, Gyeonggi-do (KR); CHOI, Jaewon, 16677 Suwon-si, Gyeonggi-do (KR); HEO, Woong, 16677 Suwon-si, Gyeonggi-do (KR)
(74) Representative: Kuhnen & Wacker Patent- und Rechtsanwaltsbüro PartG mbB

(57) **Abstract**

A semiconductor device (100) according to example embodiments of the present disclosure includes: a plate layer, gate electrodes (130) stacked and spaced apart from each other and including lower gate electrodes, memory gate electrodes, and upper gate electrodes, channel structures (CH) extending through the gate electrodes (130), first contact plugs (MC1) electrically connected to the upper gate electrodes, respectively, second contact plugs (MC2) extending through portions of the gate electrodes (130) and electrically connected to the memory gate electrodes and the lower gate electrodes, respectively, gate separation regions (MS) extending through the gate electrodes (130), and first upper separation regions (SS1) extending through the upper gate electrodes between the gate separation regions (MS). Each of the first contact plugs (MC1) may be in contact with at least one of the first upper separation regions (SS1), and the second contact plugs (MC2) may be spaced apart from the first upper separation regions (SS 1).

## Description

### BACKGROUND OF THE INVENTION

The present disclosure relates to semiconductor devices and data storage systems including the same.

In data storage systems requiring data storage, a semiconductor device capable of storing high-capacity data is helpful. Accordingly, methods of increasing data storage capacity of a semiconductor device have been researched. For example, as one of the methods of increasing the data storage capacity of a semiconductor device, a semiconductor device including memory cells arranged three-dimensionally instead of memory cells arranged two-dimensionally has been proposed.

### SUMMARY OF THE INVENTION

Aspects of the present disclosure provide a semiconductor device having an improved degree of integration.

Aspects of the present disclosure provide a data storage system including a semiconductor device having an improved degree of integration.

A semiconductor device according to example embodiments may include: a plate layer; gate electrodes stacked and spaced apart from each other in a first direction perpendicular to an upper surface of the plate layer, in first to third regions, and including lower gate electrodes, memory gate electrodes, and upper gate electrodes sequentially stacked on the plate layer; channel structures in the first region and extending through the gate electrodes in the first direction; first contact plugs extending into at least one of the upper gate electrodes and electrically connected to the upper gate electrodes, respectively, in the second region; second contact plugs extending through a portion of the gate electrodes including the upper gate electrodes and electrically connected to the memory gate electrodes and the lower gate electrodes, respectively, in the third region; gate separation regions extending through the gate electrodes, extending in a second direction perpendicular to the first direction in the first to third regions, and spaced apart from each other in a third direction perpendicular to the first and second directions; first upper separation regions extending through the upper gate electrodes between the gate separation regions, and extending in the second direction in the first and second regions; and a second upper separation region connected to ends of the first upper separation regions, extending through the upper gate electrodes, and extending in the third direction along a boundary between the second region and the third region, wherein the first contact plugs are arranged in a shape of at least one line, with the first upper separation regions between ones of the first contact plugs in the third direction, and wherein each of the first contact plugs is in contact with a side surface of at least one of the first upper separation regions in the third direction.

A semiconductor device according to example embodiments may include: a plate layer; gate electrodes stacked and spaced apart from each other in a first direction perpendicular to an upper surface of the plate layer, and including lower gate electrodes, memory gate electrodes, and upper gate electrodes sequentially stacked on the plate layer; channel structures extending through the gate electrodes in the first direction; first contact plugs electrically connected to the upper gate electrodes, respectively; second contact plugs extending through portions of the gate electrodes and electrically connected to the memory gate electrodes and the lower gate electrodes, respectively; gate separation regions extending through the gate electrodes, extending in a second direction perpendicular to the first direction, and spaced apart from each other in a third direction perpendicular to the first and second directions; and first upper separation regions extending through the upper gate electrodes between the gate separation regions, and extending in the second direction, wherein each of the first contact plugs is in contact with at least one of the first upper separation regions, and wherein the second contact plugs are spaced apart from the first upper separation regions.

A data storage system according to example embodiments may include: a semiconductor storage device including a first semiconductor structure comprising circuit elements, a second semiconductor structure on the first semiconductor structure, and an input/output pad electrically connected to the circuit elements; and a controller electrically connected to the semiconductor storage device through the input/output pad and configured to control the semiconductor storage device, wherein the second semiconductor structure comprises: a plate layer; gate electrodes stacked and spaced apart from each other on the plate layer in a first direction perpendicular to an upper surface of the plate layer, and including first gate electrodes and second gate electrodes on the first gate electrodes; first contact plugs extending in the first direction and electrically connected to the second gate electrodes, respectively; and second contact plugs adjacent to the first contact plugs in a second direction perpendicular to the first direction, extending through the second gate electrodes in the first direction, and electrically connected to the first gate electrodes, respectively, wherein the first contact plugs are arranged in columns in a third direction perpendicular to the first and second directions, and a number of the columns is equal to a number of the second gate electrodes, and wherein the second contact plugs are arranged differently from the first contact plugs.

In example embodiments, first contact plugs may be arranged to be separated by upper separation regions, thereby providing a semiconductor device having an improved degree of integration and a data storage system including the same.

Advantages and effects of the present application are not limited to the foregoing content and may be more easily understood in the process of describing specific embodiments of the present disclosure.

### BRIEF DESCRIPTION OF DRAWINGS

The above and other aspects, features, and advantages of the present disclosure will be more clearly understood from the following detailed description, taken in conjunction with the accompanying drawings, in which:
FIG. 1 is a schematic plan view of a semiconductor device according to example embodiments;
FIGS. 2A to 2C are schematic cross-sectional views of a semiconductor device according to example embodiments;
FIGS. 3A to 3C are partially enlarged views illustrating partial regions of a semiconductor device according to example embodiments;
FIGS. 4A and 4B are plan views of a semiconductor device according to example embodiments;
FIGS. 5A and 5B are plan views of a semiconductor device according to example embodiments;
FIGS. 6A and 6B are a plan view and a cross-sectional view of a semiconductor device, respectively, according to example embodiments;
FIG. 7 is a cross-sectional view of a semiconductor device according to example embodiments;
FIGS. 8, 9A, 9B, 10 to 17, 18A, 18B, and 19 to 21 are schematic plan views and cross-sectional views illustrating a method of manufacturing a semiconductor device according to example embodiments;
FIG. 22 is a view schematically illustrating a data storage system including a semiconductor device according to example embodiments; and
FIG. 23 is a perspective view schematically illustrating a data storage system including a semiconductor device according to example embodiments.

### DETAILED DESCRIPTION

Hereinafter, example embodiments of the present disclosure will be described with reference to the accompanying drawings.

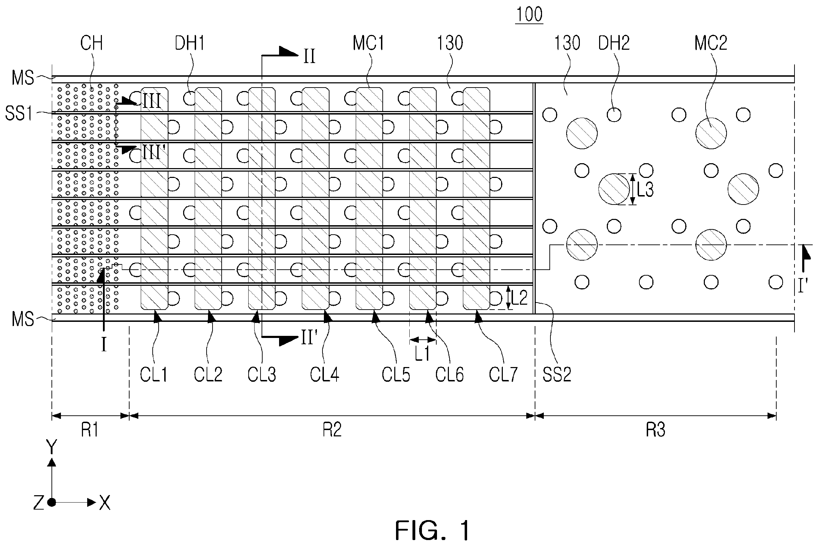

FIG. 1 is a schematic plan view of a semiconductor device according to example embodiments.

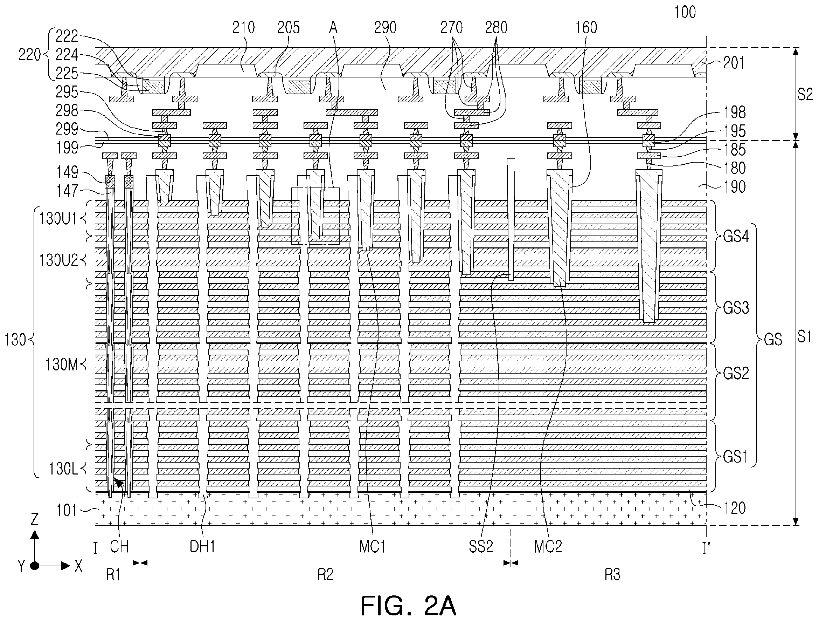

FIGS. 2A to 2C are schematic cross-sectional views of a semiconductor device according to example embodiments. In particular, FIGS. 2A to 2C are cross-sectional views taken along lines I-I', II-II', and III-III' of FIG. 1, respectively.

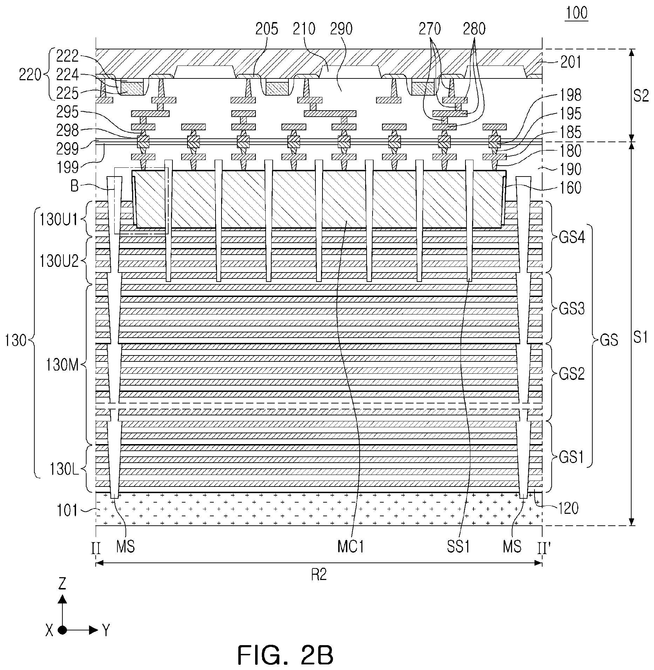

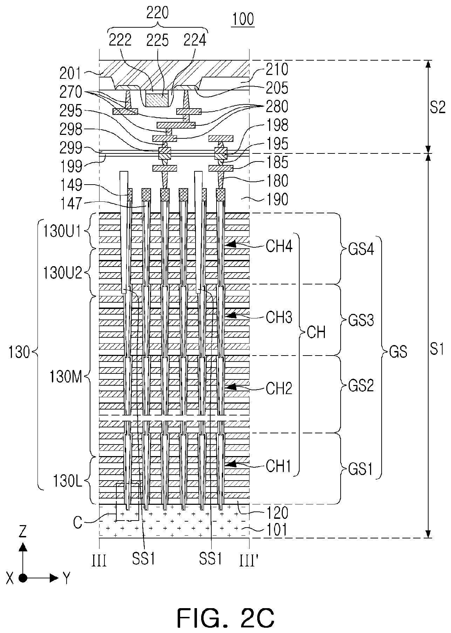

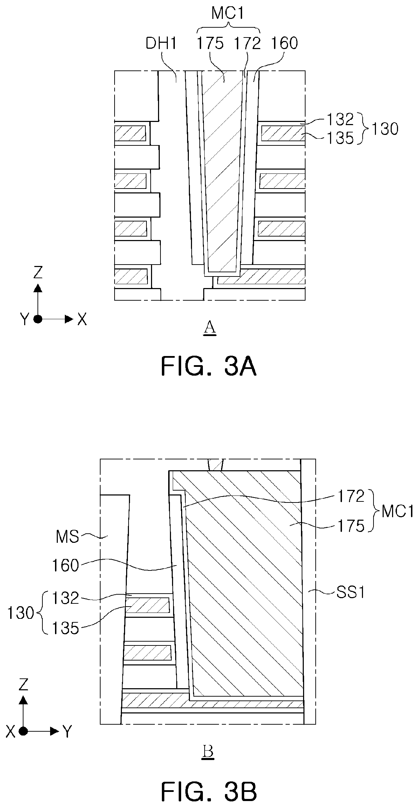

FIGS. 3A to 3C are partially enlarged views illustrating partial regions of a semiconductor device according to example embodiments. In particular, FIGS. 3A to 3C are enlarged views of region 'A' of FIG. 2A, region 'B' of FIG. 2B, and region 'C' of FIG. 2C, respectively.

Referring to FIGS. 1, 2A to 2C, and 3A to 3C, a semiconductor device 100 may include first and second semiconductor structures S1 and S2 stacked vertically. The first semiconductor structure S1 may include a memory cell region, and the second semiconductor structure S2 may include a peripheral circuit region. In some example embodiments, the second semiconductor structure S2 may be on the first semiconductor structure S1. In other example embodiments, the second semiconductor structure S2 may be disposed below the first semiconductor structure S1. FIG. 1 illustrates an arrangement of main components of the first semiconductor structure S1 on a plane.

The first semiconductor structure S1 may include first to third regions R1, R2 and R3. The first semiconductor structure S1 may include a plate layer 101, gate electrodes 130 stacked on the plate layer 101 and included in a gate structure GS, an interlayer insulating layer 120 alternately stacked with the gate electrodes 130 and included in the gate structure GS, channel structures CH disposed to penetrate (i.e., extend) through the gate structure GS in the first region R1, gate separation regions MS extending by penetrating through the gate structure GS in the first to third regions R1, R2 and R3, first and second upper separation regions SS1 and SS2 penetrating through first and second upper gate electrodes 130U1 and 130U2 disposed in upper portions of the gate electrodes 130, first contact plugs MC1 connected to the first and second upper gate electrodes 130U1 and 130U2 in the second region R2 and extending vertically, second contact plugs MC2 connected to memory gate electrodes 130M and lower gate electrodes 130L in the third region R3 and extending vertically, and first and second dummy vertical structures DH1 and DH2 disposed around the first and second contact plugs MC1 and MC2. The first semiconductor structure S1 may further include contact insulating layers 160 surrounding the first and second contact plugs MC1 and MC2, studs 180, cell interconnection lines 185, first bonding vias 195, first bonding metal layers 198, a first bonding insulating layer 199, and a cell region insulating layer 190.

In the first semiconductor structure S1, the first region R1 may be a region in which channel structures CH are disposed and may be a region in which memory cells are disposed. The second and third regions R2 and R3 may correspond to regions for electrically connecting the gate electrodes 130 to the second semiconductor structure S2. The second and third regions R2 and R3 may be sequentially disposed from the first region R1, in at least one end of the first region R1 in at least one direction, for example, an X-direction. First contact plugs MC1 and first dummy vertical structures DH1 may be disposed in the second region R2, and second contact plugs MC2 and second dummy vertical structures DH2 may be disposed in the third region R3. As used herein, the first to third regions R1, R2 and R3 may be also referred to as regions of the semiconductor device 100 or the plate layer 101, rather than as regions of the first semiconductor structure S1.

The plate layer 101 may have a shape of a plate and may function as at least a portion of a common source line of the semiconductor device 100. The plate layer 101 may include a conductive material. For example, the plate layer 101 may include a semiconductor material, such as a group IV semiconductor, a group III-V compound semiconductor, or a group II-VI compound semiconductor. For example, the group IV semiconductors may include silicon, germanium, or silicon-germanium. The plate layer 101 may further include impurities. The plate layer 101 may be provided as a polycrystalline semiconductor layer such as a polycrystalline silicon layer or an epitaxial layer.

The gate electrodes 130 may be stacked and vertically spaced apart from each other on the plate layer 101 and may be included in the gate structure GS together with the interlayer insulating layers 120. The gate structure GS may include first to fourth stack structures GS1, GS2, GS3 and GS4 that are vertically stacked. However, according to example embodiments, the number of stack structures included in the gate structure GS may be variously changed. For example, in some example embodiments, the gate structure GS may be comprised of fewer than four, or five or more stack structures, or may be comprised of a single stack structure. The number of gate electrodes 130 included in each of the first to fourth stack structures GS1, GS2, GS3 and GS4 may be identical to or different from each other.

The gate electrodes 130 may include first and second upper gate electrodes 130U1 and 130U2 included in string select transistors and erase transistors, memory gate electrodes 130M included in a plurality of memory cells, and lower gate electrodes 130L included in ground select transistors. The number of memory gate electrodes 130M may be determined according to the capacity of the semiconductor device 100. The first upper gate electrodes 130U1 may be included in the erase transistors, and the second upper gate electrodes 130U2 may be included in the string select transistors. The second upper gate electrodes 130U2 may be disposed between the first upper gate electrodes 130U1 and the memory gate electrodes 130M. In some example embodiments, the first upper gate electrodes 130U1 may be omitted. In some example embodiments, the lower gate electrodes 130L may further include a gate electrode of the erase transistor. According to example embodiments, the number of gate electrodes 130 included in the first and second upper gate electrodes 130U1 and 130U2 and the lower gate electrodes 130L may be variously changed. Some gate electrodes 130, for example, memory gate electrodes 130M adjacent to the second upper gate electrodes 130U2 and/or the lower gate electrodes 130L may be dummy gate electrodes. As used herein, the gate electrodes 130 excluding the first and second upper gate electrodes 130U1 and 130U2, among the gate electrodes 130, may be referred to as first gate electrodes, and the first and second upper gate electrodes 130U1 and 130U2 may also be referred to as second gate electrodes.

As illustrated in FIG. 1, the gate electrodes 130 may be disposed to be separated from each other in a Y-direction, by the gate separation regions MS continuously extending from the first to third regions R1, R2 and R3. The gate electrodes 130 between a pair of gate separation regions MS may be included in one memory block, but the scope of the memory block is not limited thereto. For example, the X-direction and the Y-direction may be perpendicular to each other, and may be substantially parallel to an upper surface of the plate layer 101.

The gate electrodes 130 may be stacked and vertically spaced apart from each other in the first to third regions R1, R2 and R3. The gate electrodes 130 do not have a stepwise shape (i.e., a staircase shape) in the second and third regions R2 and R3, and may have a shape in which all gate electrodes 130 are stacked. Accordingly, some of the first contact plugs MC1 and the second contact plugs MC2 may be connected to the gate electrode 130 by penetrating through at least one gate electrode 130 from an upper portion. Ends of the gate electrodes 130 in the X-direction may be disposed outside the third region R3. For example, ends of the gate electrodes 130 in the X-direction may extend beyond the third region R3.

As illustrated in FIGS. 3A to 3C, each of the gate electrodes 130 may include a gate barrier layer 132 and a gate conductive layer 135. The gate barrier layer 132 may be on (e.g., may cover) an upper surface and a lower surface of the gate conductive layer 135 and portions of side surfaces thereof. The gate barrier layer 132 may expose the gate conductive layer 135 on a side surface of the gate electrode 130 in contact with the gate separation regions MS, among the side surfaces of the gate electrode 130, and may be on (e.g., may cover) the gate conductive layer 135 on a side surface of the gate electrode 130 in contact with the channel structures CH, the first and second dummy vertical structures DH1 and DH2, and the contact insulating layers 160. In some example embodiments, at least a portion of the gate barrier layer 132 may extend along lower surfaces of the first and second contact plugs MC1 and MC2.

The gate electrodes 130 may include a conductive material such as a metal material or a semiconductor material. For example, the gate barrier layer 132 may include tungsten nitride (WN), tantalum nitride (TaN), titanium nitride (TiN), or combinations thereof, and the gate conductive layer 135 may include tungsten (W).

The interlayer insulating layers 120 may be disposed between the gate electrodes 130. The interlayer insulating layers 120 may also be spaced apart from each other in a direction, perpendicular to an upper surface of the plate layer 101, and extend in the X-direction, similarly to the gate electrodes 130. The interlayer insulating layers 120 may include an insulating material such as silicon oxide or silicon nitride. In example embodiments, thicknesses of each of the interlayer insulating layers 120 may be variously changed.

The channel structures CH may extend in a Z-direction by penetrating through the gate electrodes 130, and may be connected to the plate layer 101. For example, the Z-direction may be perpendicular to the X-direction and the Y-direction, and may be substantially perpendicular to the upper surface of the plate layer 101. Each of the channel structures CH may be included in one memory cell string, and may be arranged to form rows and columns on the plate layer 101 in the first region R1 and spaced apart from each other. The channel structures CH may be arranged to have a grid pattern in an X-Y plane or may be arranged in a zigzag shape in one direction. The channel structures CH may have a pillar shape, and may have an inclined side surface that become narrower as the channel structures CH approach the plate layer 101. For example, thirty-two channel structures CH may be arranged in the Y-direction between the pair of gate separation regions MS, but the number of channel structures CH and the resulting arrangement may be variously changed in example embodiments.

Each of the channel structures CH may include first to fourth channel portions CH1, CH2, CH3 and CH4 that are vertically stacked. The first to fourth channel portions CH1, CH2, CH3 and CH4 may penetrate through the first to fourth gate structures GS1, GS2, GS3 and GS4 of the gate structure GS, respectively. The first to fourth channel portions CH1, CH2, CH3 and CH4 may be connected to each other, and may have a shape in which a width of an upper surface of a channel portion disposed in a lower portion is larger than a width of a lower surface of a channel portion disposed in an upper portion in a region in which the first to fourth channel portions CH1, CH2, CH3 and CH4 are connected or an interfacial surface thereof. The channel structure CH may have bent portions caused by different widths in the interfacial surface between the first to fourth channel portions CH1, CH2, CH3 and CH4. A lower end of the first channel portion CH1 may be disposed in the plate layer 101.

Each of the channel structures CH may include a channel layer 140, a channel dielectric layer 145, a channel buried insulating layer 147, and a channel pad 149 disposed in a channel hole. The channel layer 140, the channel dielectric layer 145 and the channel buried insulating layer 147 may be connected to each other between the first to fourth channel portions CH1, CH2, CH3 and CH4.

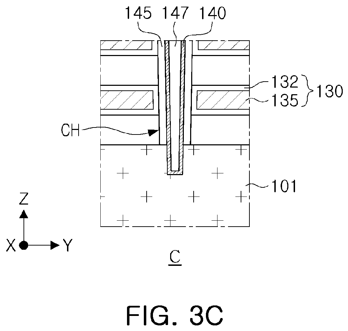

As illustrated in an enlarged view of FIG. 3C, the channel layer 140 may be formed to have an annular shape surrounding the internal channel buried insulating layer 147. The channel layer 140 in the plate layer 101 may be exposed from the channel dielectric layer 145 to contact the plate layer 101, and may be electrically connected to the plate layer 101. The channel layer 140 may include a semiconductor material such as polycrystalline silicon or single crystalline silicon.

The channel dielectric layer 145 may be disposed between the gate electrodes 130 and the channel layer 140. Although not specifically illustrated, the channel dielectric layer 145 may include a tunneling layer, a charge storage layer, and a blocking layer sequentially stacked from the channel layer 140. The tunneling layer may tunnel charges into the charge storage layer, and may include, for example, silicon oxide (SiO₂), silicon nitride (Si₃N₄), silicon oxynitride (SiON), or combinations thereof. The charge storage layer may be a charge trapping layer or a floating gate conductive layer. The blocking layer may include silicon oxide (SiO₂), silicon nitride (Si₃N₄), silicon oxynitride (SiON), high-κ dielectric materials or combinations thereof. In example embodiments, at least a portion of channel dielectric layer 145 may extend in a horizontal direction along the gate electrodes 130. The channel pad 149 may be disposed only in an upper end of the fourth channel portion CH4 in an upper portion. The channel pad 149 may include, for example, doped polycrystalline silicon.

The gate separation regions MS may penetrate through the gate electrodes 130 and may extend in the X-direction. As illustrated in FIG. 1, the gate separation regions MS may be disposed in parallel with each other. However, the arrangement form and number of gate separation regions MS are not limited to those illustrated in FIG. 1. For example, in some embodiments, the gate separation region MS may be further disposed to have an intermittent form in the first to third regions R1, R2 and R3.

As illustrated in FIG. 2B, the gate separation regions MS may penetrate through the gate electrodes 130 stacked on the plate layer 101, and may thus be connected to the plate layer 101. The gate separation regions MS may have a shape in which a width thereof decreases toward the plate layer 101 due to a high aspect ratio. The gate separation regions MS may have bent portions corresponding to the first to fourth channel portions CH1, CH2, CH3 and CH4. Although not specifically illustrated in FIG 1, the gate separation regions MS may have curved side surfaces in the Y-direction in a plan view. The gate separation regions MS may include an insulating material, and may include, for example, silicon oxide, silicon nitride, or silicon oxynitride.

The first upper separation regions SS1 may extend in the X-direction between the pair of gate separation regions MS, as illustrated in FIG. 1. The first upper separation regions SS1 may be disposed in the first and second regions R1 and R2. The first upper separation regions SS1 may penetrate through the first and second upper gate electrodes 130U1 and 130U2, among the gate electrodes 130. As illustrated in FIG. 1, the first upper separation regions SS1 may divide each of the first and second upper gate electrodes 130U1 and 130U2 into eight layers in the Y-direction between the pair of gate separation regions MS. However, in example embodiments, the number of first upper separation regions SS1 disposed between the pair of gate separation regions MS may be variously changed.

The first upper separation regions SS1 may be disposed between the first contact plugs MC1, as illustrated in FIGS. 1 and 2B. The first upper separation regions SS1 may be interposed between the first contact plugs MC1 adjacent to each other in the Y-direction and may space the first contact plugs MC1 apart from each other. The first upper separation regions SS1 may penetrate through the first contact plugs MC1 included in each of first to seventh columns CL1, CL2, CL3, CL4, CL5, CL6 and CL7 in the Y-direction. Side surfaces of the first upper separation regions SS1 in the Y-direction may be in contact with the first contact plugs MC1.

The first upper separation regions SS1 may be disposed to partially cut portions of the channel structures CH, as illustrated in FIGS. 1 and 2C. For example, the first upper separation regions SS1 may extend into portions of the channel structures CH. The first upper separation regions SS1 may extend by partially penetrating through some of the channel structures CH, and may thus contact the channel layer 140. In example embodiments, relative arrangements of the first upper separation regions SS1 and the channel structures CH partially penetrated by the first upper separation regions SS1 in the plan view of FIG. 1 may be variously changed.

The second upper separation region SS2 may be connected to the ends of the first upper separation regions SS1 in boundaries between the second region R2 and the third region R3 and may extend in the Y-direction, as illustrated in FIG. 1. The second upper separation region SS2 may be disposed on the same level as a level of the first upper separation regions SS1 and may have the same depth. For example, a lower surface of the second upper separation region SS2 may be coplanar with lower surfaces of the first upper separation regions SS1. A width of the second upper separation region SS2 may be identical to or different from widths of the first upper separation regions SS1. By the first and second upper separation regions SS1 and SS2, each of the first and second upper gate electrodes 130U1 and 130U2 may be divided into eight electrodes and may receive separate electrical signals.

The first and second upper separation regions SS1 and SS2 may include an insulating material, and may include, for example, silicon oxide, silicon nitride, or silicon oxynitride.

The first and second contact plugs MC1 and MC2 may be physically and electrically connected to the gate electrodes 130. The first contact plugs MC1 may be connected to the first and second upper gate electrodes 130U1 and 130U2 in the second region R2 adjacent to the first region R1. The second contact plugs MC2 may be connected to the memory gate electrodes 130M and the lower gate electrodes 130L in the third region R3 outside the second region R2.

As illustrated in FIG. 1, the first contact plugs MC1 may be arranged to form first to seventh columns CL1, CL2, CL3, CL4, CL5, CL6 and CL7 in the Y-direction in a plan view. The first contact plugs MC1 in each of the first to seventh columns CL1, CL2, CL3, CL4, CL5, CL6 and CL7 may have a shape of a single line in which the first upper separation regions SS1 are interposed. However, in example embodiments, a specific shape of the line shape, for example, a width, a degree of rounding of corners, and the like, may be variously changed. The first to seventh columns CL1, CL2, CL3, CL4, CL5, CL6 and CL7 may be spaced apart from each other in the X-direction.

The first contact plugs MC1 in which the same columns, among the first to seventh columns CL1, CL2, CL3, CL4, CL5, CL6 and CL7, are formed, may extend at the same depth as each other, and the first contact plugs MC1 in different columns may have different depths. For example, lower surfaces of the first contact plugs MC1 in the same column, among the first to seventh columns CL1, CL2, CL3, CL4, CL5, CL6 and CL7, may be coplanar. Lower surfaces of the first contact plugs MC1 in different columns, among the first to seventh columns CL1, CL2, CL3, CL4, CL5, CL6 and CL7, may be non-coplanar. For example, the first contact plugs MC1 in the first column CL1 may be connected to first upper gate electrodes 130U1 in an uppermost portion, respectively, and the first contact plugs MC1 in the second column CL2 may be connected to first upper gate electrodes 130U1 therebelow, respectively. The number of columns may be the same as the number of first and second upper gate electrodes 130U1 and 130U2. The number of first contact plugs MC1 arranged to form each of the first to seventh columns CL1, CL2, CL3, CL4, CL5, CL6 and CL7 may be one more than the number of first upper separation regions SS1. For example, a number of the first contact plugs MC1 between an adjacent pair of the first upper separation regions SS1 in the Y-direction may be equal to a number of the first and second upper gate electrodes 130U1 and 130U2. The first contact plugs MC1 between the adjacent pair of the first upper separation regions SS1 in the Y-direction may be respectively included in the first to seventh columns CL1, CL2, CL3, CL4, CL5, CL6 and CL7.

The first contact plugs MC1 may penetrate through at least one of the first and second upper gate electrodes 130U1 and 130U2, except for the first contact plugs MC1 connected to the first upper gate electrode 130U1 in the uppermost portion, and may thus be connected to the first and second upper gate electrodes 130U1 and 130U2, respectively. The first contact plugs MC1 may be electrically separated from respective ones of the first and second upper gate electrodes 130U1 and 130U2 by the contact insulating layers 160.

At least one of first side surfaces of each of the first contact plugs MC1 in the Y-direction may be in contact with the first upper separation regions SS1. In other words, each of the first contact plugs MC1 may be in contact with a side surface of at least one of the first upper separation regions SS1 in the Y-direction. For example, opposing side surfaces of the first upper separation regions SS1 in the Y-direction may be in contact with respective ones of the first contact plugs MC1. In a plan view, each of the first contact plugs MC1 disposed between first upper separation regions SS1 adjacent to each other in the Y-direction, among the first contact plugs MC1 may be in contact with all of the adjacent first upper separation regions SS1. External surfaces of the first side surfaces of the first contact plugs MC1 disposed in both ends of each of the first to seventh columns CL1, CL2, CL3, CL4, CL5, CL6 and CL7 in the Y-direction may be covered with the contact insulating layers 160 (e.g., see FIG. 2B). Second side surfaces of the first contact plugs MC1 in the X-direction may be covered with contact insulating layers 160 (e.g., see FIG. 2A).

The second contact plugs MC2 may be disposed in the third region R3, and may have a different shape from the first contact plugs MC1 in a plan view and may be arranged in a different form or pattern. The second contact plugs MC2 may have a circular or oval shape in a plan view, and may be spaced apart from each other in the X-direction and Y-direction, as illustrated in FIG. 1. The second contact plugs MC2 may be arranged in a grid shape or a zigzag shape.

The second contact plugs MC2 may be spaced apart from each other by at least a portion of the gate electrodes 130. The gate electrodes 130 may be interposed between the second contact plugs MC2 adjacent to each other. Side surfaces of each of the second contact plugs MC2 may be covered with the contact insulating layer 160. The second contact plugs MC2 may penetrate through both the first and second upper gate electrodes 130U1 and 130U2 and may thus be connected to the memory gate electrodes 130M and the lower gate electrodes 130L, respectively. The number of second contact plugs MC2 disposed between the pair of gate separation regions MS may be equal to or greater than the number of memory gate electrodes 130M and lower gate electrodes 130L.

The first contact plug MC1 may have a width of a first length L1 in the X-direction, and may have a width of a second length L2 in the Y-direction. For example, the second length L2 may be equal to or greater than the first length L1, but the present disclosure is not limited thereto. The second length L2 may range from, for example, about 400 nanometers (nm) to 550 nm. The second contact plug MC2 may have a diameter or a width of a third length L3. The third length L3 may be equal to or greater than the second length L2. However, in example embodiments, relative sizes of the first contact plug MC1 and the second contact plug MC2 may be variously changed.

The first and second contact plugs MC1 and MC2 may extend in the Z-direction from the upper portion only to the gate electrode 130 electrically connected thereto. The first and second contact plugs MC1 and MC2 may be connected by partially recessing the gate electrodes 130 from upper surfaces thereof. However, a depth at which the first and second contact plugs MC1 and MC2 recess the gate electrodes 130 may be variously changed in example embodiments. Each of the first and second contact plugs MC1 and MC2 may have a shape expanded horizontally in an upper end thereof. For example, a width of each of the first and second contact plugs MC1 and MC2 in the X-direction may decrease toward the plate layer 101.

As illustrated in FIGS. 3A and 3B, each of the first and second contact plugs MC1 and MC2 may include a contact barrier layer 172 and a contact conductive layer 175 on the contact barrier layer 172. The contact barrier layer 172 may be on (e.g., may cover) portions of a lower surface and side surfaces of the contact conductive layer 175. For example, in the first contact plugs MC1, the contact barrier layer 172 may cover all side surfaces of the contact conductive layer 175 in the X-direction, and may cover side surfaces that are not in contact with the first upper separation regions SS1, among the side surfaces of the contact conductive layer 175 in the Y-direction. On a side surface of the first contact plug MC1 in contact with the first upper separation region SS1, among side surfaces of the first contact plug MC1, the contact conductive layer 175 may be exposed from the contact barrier layer 172 and may be in direct contact with the first upper separation region SS1.

The first and second contact plugs MC1 and MC2 may include a conductive material, and may include, for example, at least one of tungsten (W), copper (Cu), aluminum (Al), or alloys thereof. For example, the contact barrier layer 172 may include tungsten nitride (WN), tantalum nitride (TaN), titanium nitride (TiN), or combinations thereof, and the contact conductive layer 175 may include tungsten (W).

The contact insulating layers 160 may be disposed on portions of the side surfaces of each of the first contact plugs MC1, and may be disposed on each side surface of the second contact plugs MC2. Lower ends of the contact insulating layers 160 may be disposed on a level higher than a level of lower ends of the first and second contact plugs MC1 and MC2, but the present disclosure is not limited thereto. As used herein, the term "level" refers to a height or distance in the Z-direction (e.g., a vertical direction) from the upper surface of the plate layer 101. The contact insulating layers 160 may include an insulating material, and may include, for example, silicon oxide, silicon nitride, or silicon oxynitride.

The first dummy vertical structures DH1 may be spaced apart from each other to form rows and columns on the plate layer 101 in the second region R2. As illustrated in FIG. 1, the first dummy vertical structures DH1 may partially overlap the first contact plugs MC1 in a plan view and may be arranged in a zigzag shape. As used herein, "an element A overlaps an element B in a direction" (or similar language) means that there is at least one straight line that extends in the direction and intersects both the elements A and B.

The second dummy vertical structures DH2 may be spaced apart from each other to form rows and columns on the plate layer 101 in the third region R3. As illustrated in FIG. 1, the second dummy vertical structures DH2 may be arranged in a regular pattern around the second contact plugs MC2. The second dummy vertical structures DH2 may be arranged in a different pattern from the first dummy vertical structures DH1. However, in some example embodiments, the arrangement forms of the first and second dummy vertical structures DH1 and DH2 may be identical to each other, and each specific pattern may be variously changed.

The first and second dummy vertical structures DH1 and DH2 may have a circular shape, an oval shape, or a shape similar thereto in a plan view. The first and second dummy vertical structures DH1 and DH2 may have a pillar shape penetrating through the gate electrodes 130, and may have an inclined side surface that becomes narrower as the first and second dummy vertical structures DH1 and DH2 approach the plate layer 101 depending on the aspect ratio. The first and second dummy vertical structures DH1 and DH2 may have the same diameter, and the diameters of the first and second dummy vertical structures DH1 and DH2 may be greater than diameters of the channel structures CH, but the present disclosure is not limited thereto. In some example embodiments, the second dummy vertical structures DH2 may have greater diameters than the diameters of the first dummy vertical structures DH1.

The first and second dummy vertical structures DH1 and DH2 may include regions protruding from side surfaces thereof toward the gate electrodes 130. The first and second dummy vertical structures DH1 and DH2 may have bent portions corresponding to the first to fourth channel portions CH1, CH2, CH3 and CH4. The first dummy vertical structures DH1 may be in contact with portions of the side surfaces of the first contact plugs MC1 in the X-direction.

The first and second dummy vertical structures DH1 and DH2 may not include a conductive layer and may include an insulating material. The first and second dummy vertical structures DH1 and DH2 may include, for example, silicon oxide, silicon nitride, or silicon oxynitride.

The cell region insulating layer 190 may be disposed to be on (e.g., to cover) the gate structure GS. The cell region insulating layer 190 may include a plurality of insulating layers according to example embodiments. The cell region insulating layer 190 may be formed of an insulating material, and may include, for example, at least one of silicon oxide, silicon nitride, or silicon oxynitride.

The studs 180 and the cell interconnection lines 185 may be included in a cell interconnection structure electrically connected to the memory cells. The studs 180 may be connected to the channel structures CH and the first and second contact plugs MC1 and MC2 by penetrating through a portion of the cell region insulating layer 190, and may be electrically connected to the channel layers 140 and the gate electrodes 130. The studs 180 may have a plug shape, and the cell interconnection lines 185 may have a line shape, but the present disclosure is not limited thereto. The studs 180 and the cell interconnection lines 185 may include a metal, for example, tungsten (W), copper (Cu), and aluminum (Al).

The first bonding vias 195, the first bonding metal layers 198, and first bonding insulating layer 199 may be included in a first bonding structure of the first semiconductor structure S1. The first bonding vias 195 may be disposed on the cell interconnection lines 185, and the first bonding metal layers 198 may be connected to the first bonding vias 195. Upper surfaces of the first bonding metal layers 198 may be exposed to an upper surface of the first semiconductor structure S1. The first bonding metal layers 198 may be bonded and connected to the second bonding metal layers 298 of the second semiconductor structure S2. The first bonding vias 195 and the first bonding metal layers 198 may include a conductive material, for example, copper (Cu). The first bonding insulating layer 199 may form dielectric-dielectric bonding with the second bonding insulating layer 299 of the second semiconductor structure S2. The first bonding insulating layer 199 may include, for example, at least one of SiO, SiN, SiCN, SiOC, SiON, or SiOCN.

A peripheral circuit region of the second semiconductor structure S2 may include a substrate 201, source/drain regions 205 and device isolating layers 210 in the substrate 201, circuit elements 220 disposed on the substrate 201, a peripheral region insulating layer 290, circuit contact plugs 270, circuit interconnection lines 280, second bonding vias 295, second bonding metal layers 298, and second bonding insulating layer 299.

The substrate 201 may have a lower surface extending in the X-direction and the Y-direction. An active region may be defined on the substrate 201 by the device isolating layers 210. The source/drain regions 205 including impurities may be disposed in a portion of the active region. The substrate 201 may include a semiconductor material, such as a group IV semiconductor, a group III-V compound semiconductor, or a group II-VI compound semiconductor. The substrate 201 may be provided as a bulk wafer or an epitaxial layer.

The circuit elements 220 may include planar transistors. Each of the circuit elements 220 may include a circuit gate dielectric layer 222, a spacer layer 224, and a circuit gate electrode 225. The source/drain regions 205 may be disposed as source/drain regions in the substrate 201 on both (i.e., opposite) sides of the circuit gate electrode 225.

The peripheral region insulating layer 290 may be disposed to be on (e.g., to cover) the circuit elements 220 on a lower surface of the substrate 201. The peripheral region insulating layer 290 may include a plurality of insulating layers formed in different process operations. The peripheral region insulating layer 290 may be formed of an insulating material.

The circuit contact plugs 270 and the circuit interconnection lines 280 may be included in a circuit interconnection structure electrically connected to the circuit elements 220 and the source/drain regions 205. The circuit contact plugs 270 have a cylindrical shape, and the circuit interconnection lines 280 may have a line shape. An electrical signal may be applied to the circuit element 220 by the circuit contact plugs 270 and the circuit interconnection lines 280. In a region not illustrated, the circuit contact plugs 270 may also be connected to the circuit gate electrode 225. The circuit interconnection lines 280 may be connected to circuit contact plugs 270, and may be arranged in a plurality of layers. The circuit contact plugs 270 and the circuit interconnection lines 280 may include a conductive material, and may include, for example, tungsten (W), copper (Cu), and aluminum (Al), each of which may further include a diffusion barrier layer. In example embodiments, the number of layers of the circuit contact plugs 270 and the circuit interconnection lines 280 may be variously changed.

The second bonding vias 295, the second bonding metal layers 298, and the second bonding insulating layer 299 may be included in a second bonding structure, and may be disposed below portions of the circuit interconnection lines 280 in a lowermost portion. The second bonding vias 295 may have a cylindrical shape, and the second bonding metal layers 298 may have a circular pad shape or a relatively short line shape on a plane. Lower surfaces of the second bonding metal layers 298 may be exposed to a lower surface of the second semiconductor structure S2. The second bonding vias 295 and the second bonding metal layers 298 may provide an electrical connection path with the first semiconductor structure S1. In example embodiments, portions of the second bonding metal layers 298 may not be connected to the circuit interconnection lines 280 and may be disposed only for bonding. The second bonding vias 295 and the second bonding metal layers 298 may include a conductive material, for example, copper (Cu).

The second bonding insulating layer 299 may be disposed to have a predetermined thickness from a lower surface of the peripheral region insulating layer 290. The second bonding insulating layer 299 may be a layer for dielectric-to-dielectric bonding with the first bonding insulating layer 199 of the first semiconductor structure S1. The second bonding insulating layer 299 may also function as a diffusion barrier layer for the second bonding metal layers 298, and may include, for example, at least one of SiO, SiN, SiCN, SiOC, SiON, or SiOCN.

The first and second semiconductor structures S1 and S2 may be bonded by bonding the first bonding metal layers 198 and the second bonding metal layers 298 and by bonding the first bonding insulating layer 199 and the second bonding insulating layer 299. The bonding of the first bonding metal layers 198 and the second bonding metal layers 298 may be, for example, copper (Cu)-to-copper (Cu) bonding, and the bonding of the first bonding insulating layer 199 and the second bonding insulating layer 299 may be dielectric-to-dielectric bonding, for example, SiCN-to-SiCN bonding. The first and second semiconductor structures S1 and S2 may be bonded by hybrid bonding including copper (Cu)-to-copper (Cu) bonding and dielectric-to-dielectric bonding.

The first and second semiconductor structures S1 and S2 may be packaged in a form in which the first semiconductor structure S1 is disposed below the second semiconductor structure S2, as illustrated in FIGS. 2A to 2C, or alternatively, the first and second semiconductor structures S1 and S2 may be packaged upside down in a form in which the second semiconductor structure S2 is disposed below the first semiconductor structure S1.

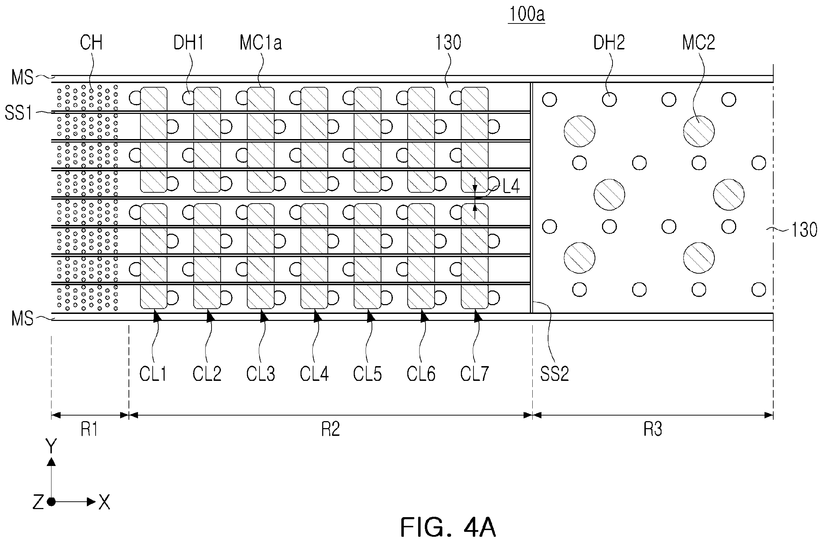

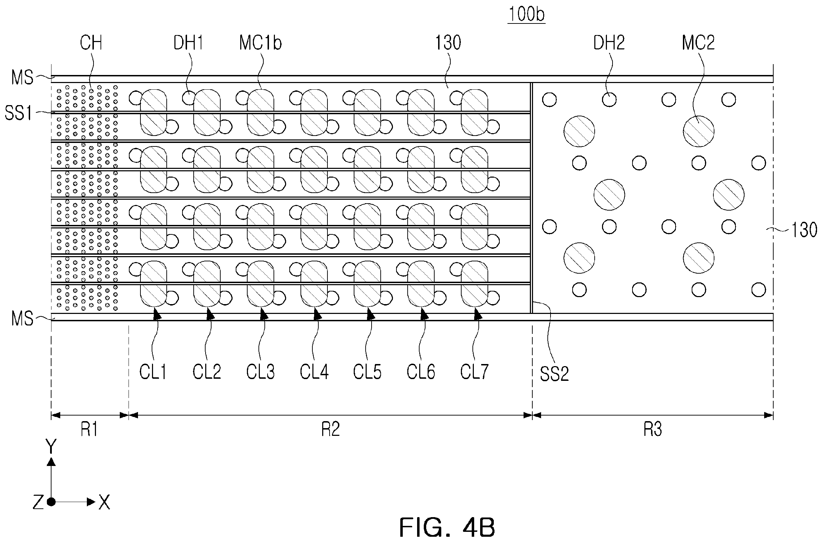

FIGS. 4A and 4B are plan views of a semiconductor device according to example embodiments.

Referring to FIG. 4A, in a semiconductor device 100a, first contact plugs MC1a may be disposed in a shape of a plurality of lines in which first upper separation regions SS1 are interposed in the Y-direction between a pair of gate separation regions MS. The first contact plugs MC1a may be disposed in two lines in which the first upper separation regions SS1 are interposed, in each of the first to seventh columns CL1, CL2, CL3, CL4, CL5, CL6 and CL7. A separation distance L4 between the two lines, a degree of rounding of corners in the plan view, and the like, may be variously changed in example embodiments.

In the present example embodiment, a first upper separation region SS1 disposed in the center in the Y-direction in the plan view, among the first upper separation regions SS1, may not contact the first contact plugs MC1a.

Referring to FIG. 4B, in a semiconductor device 100b, first contact plugs MC1b may be disposed in four lines with the first upper separation regions SS1 interposed therebetween, in each of the first to seventh columns CL1, CL2, CL3, CL4, CL5, CL6, and CL7. In the present example embodiment, the first contact plugs MC1b may be described as having a rectangular shape or an oval shape. In each of the first contact plugs MC1b, one side surface thereof in the Y-direction may be in contact with the first upper separation region SS1, and the other side surface thereof may be spaced apart from the first upper separation region SS1.

Among the first upper separation regions SS1, in the Y-direction in the plan view, a first upper separation region SS1 in contact with the first contact plugs MC1b and a first upper separation region SS1 not in contact with the first contact plugs MC1b may be alternately disposed.

In this manner, in example embodiments, the first contact plugs MC1a and MC1b may be disposed in the shape of the plurality of lines in the Y-direction between the pair of gate separation regions MS, and the number of the plurality of lines may be variously changed in example embodiments.

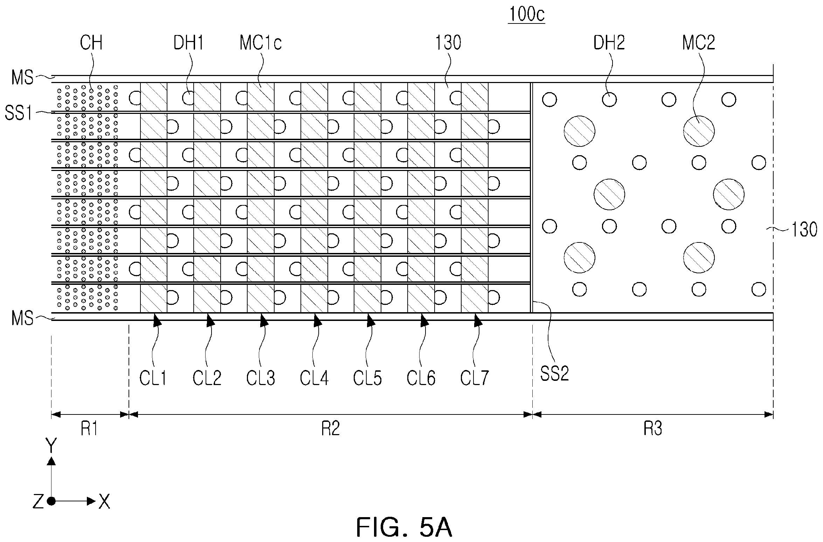

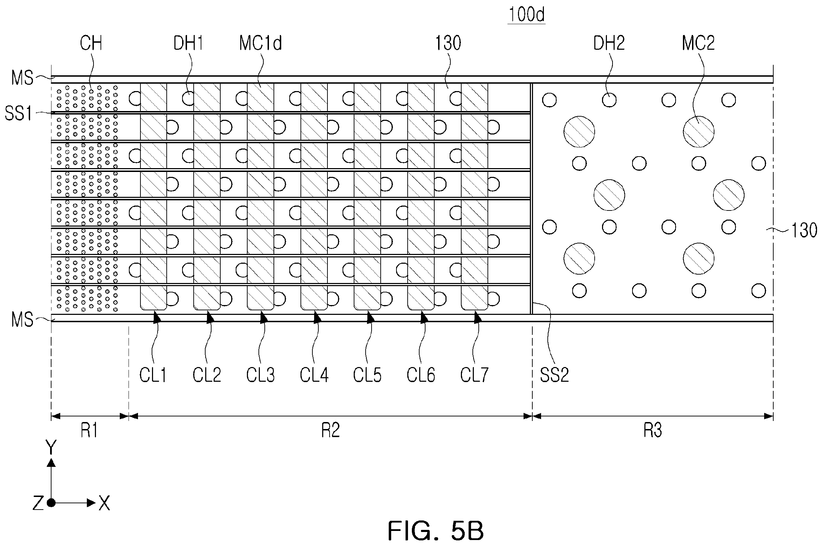

FIGS. 5A and 5B are plan views of a semiconductor device according to example embodiments.

Referring to FIG. 5A, in a semiconductor device 100c, first contact plugs MC1c adjacent to the gate separation regions MS in the Y-direction may be in contact with the gate separation regions MS. In each of the first to seventh columns CL1, CL2, CL3, CL4, CL5, CL6 and CL7, two first contact plugs MC1c disposed in both ends in the Y-direction may be contact with the gate separation regions MS.

Referring to FIG. 5B, in a semiconductor device 100d, among first contact plugs MC1d adjacent to the gate separation regions MS in the Y-direction, some of the first contact plugs MC1d may be in contact with the gate separation regions MS and other first contact plugs MC1d may be spaced apart from the gate separation regions MS. In each of the first to seventh columns CL1, CL2, CL3, CL4, CL5, CL6 and CL7, the first contact plugs MC1d disposed in one end thereof in the Y-direction may be in contact with the gate separation region MS, and the first contact plugs MC1d disposed in the other end thereof may be spaced apart from the gate separation regions MS.

In this manner, in example embodiments, the first contact plugs MC1c and MC1d may have structures formed by being patterned over a plurality of memory blocks.

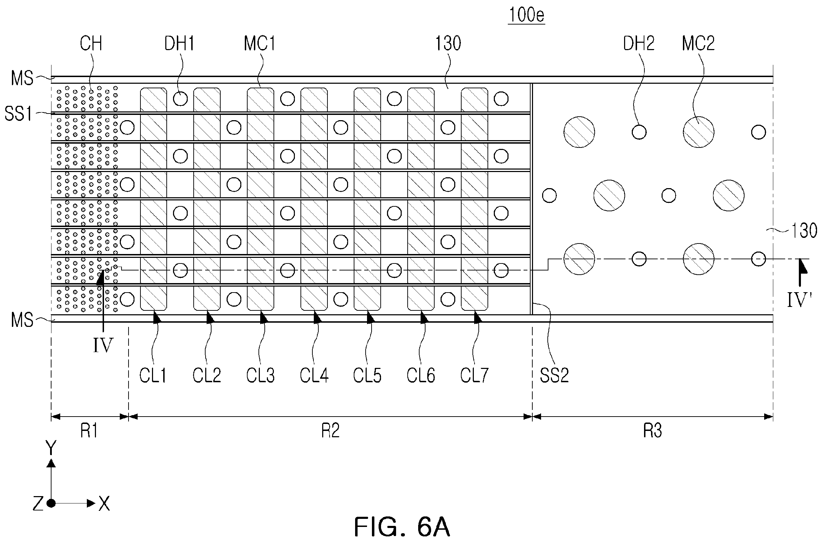

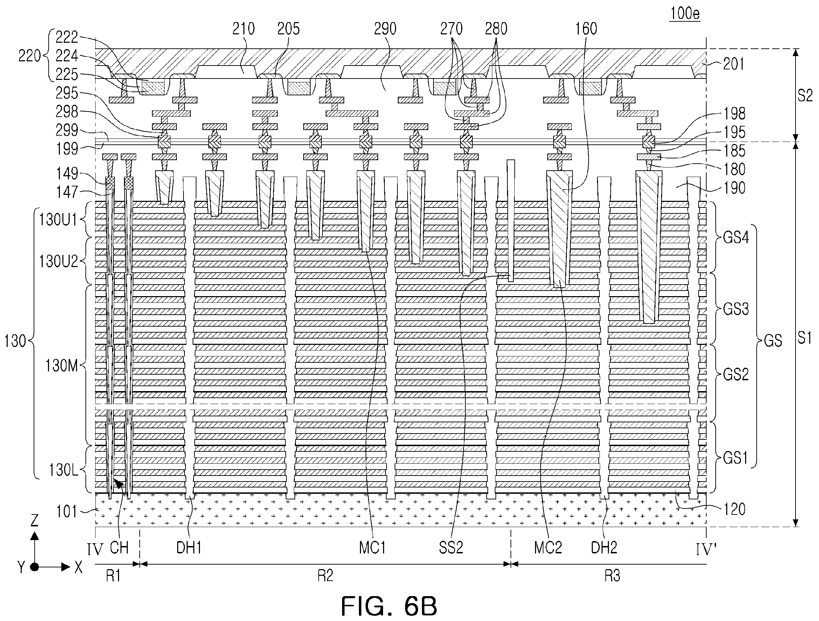

FIGS. 6A and 6B are a plan view and a cross-sectional view of a semiconductor device, respectively, according to example embodiments. In particular, FIG. 6B illustrates a cross-sectional view taken along line IV-IV' in FIG. 6A.

Referring to FIGS. 6A and 6B, in a semiconductor device 100e, arrangements of first and second dummy vertical structures DH1 and DH2 may be different from those described with reference to FIGS. 1, 2A to 2C, and 3A to 3C. The first dummy vertical structures DH1 may be disposed so as not to overlap first contact plugs MC1 in a plan view. Accordingly, as illustrated in FIG. 6B, in the cross-sectional view, the first dummy vertical structures DH1 may be spaced apart from the first contact plugs MC1. The second dummy vertical structures DH2 may be arranged in a certain pattern, for example, a hexagonal shape, along with the second contact plugs MC2 between the second contact plugs MC2.

In this manner, in example embodiments, the arrangements of the first and second dummy vertical structures DH1 and DH2 may be changed independently of each other. In example embodiments, the arrangements of the first and second dummy vertical structures DH1 and DH2 of FIG. 1 and the arrangements of the first and second dummy vertical structures DH1 and DH2 of this example embodiment may be independently combined with each other, respectively.

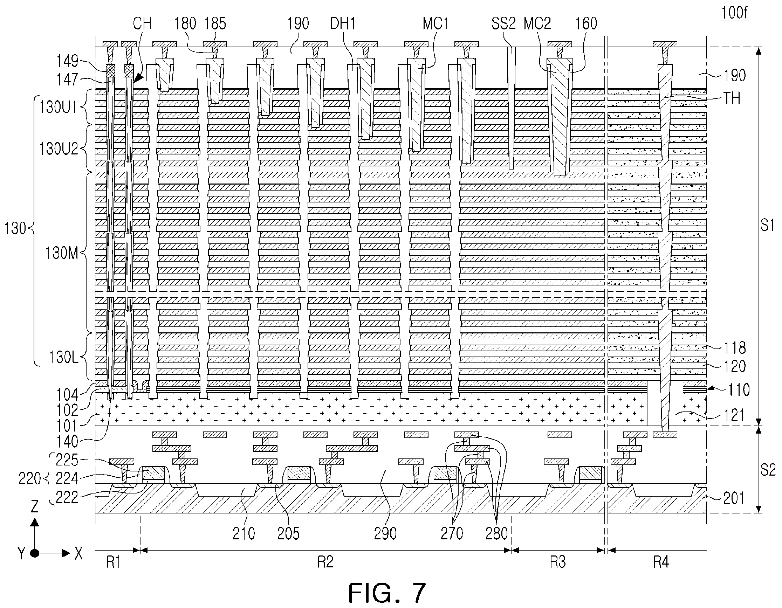

FIG. 7 is a cross-sectional view of a semiconductor device according to example embodiments.

Referring to FIG. 7, in a semiconductor device 100f, a second semiconductor structure S2 may be disposed below a first semiconductor structure S1. The second semiconductor structure S2 may further include a fourth region R4, and may further include a through-via TH, first and second horizontal conductive layers 102 and 104, a horizontal insulating layer 110, and a substrate insulating layer 121, disposed in the fourth region R4. In the semiconductor device 100f, the first semiconductor structure S1 may have a structure formed on the second semiconductor structure S2 rather than being bonded to the second semiconductor structure S2. Accordingly, the first and second semiconductor structures S1 and S2 may not include the bonding structures described above.

The fourth region R4 may be a region in which gate electrodes 130 do not extend. In the fourth region R4, sacrificial insulating layers 118 may be alternately stacked with interlayer insulating layers 120 on the plate layer 101. The through-via TH may penetrate through a stack structure of the sacrificial insulating layers 118 and the interlayer insulating layers 120 and may thus extend into the second semiconductor structure S2. However, in some example embodiments, the through-via TH may be disposed to penetrate through an insulating region formed after the sacrificial insulating layers 118 are removed.

The through-via TH may electrically connect a cell interconnection line 185 and a circuit interconnection line 280. The through-via TH may be electrically separated (i.e., insulated) from the plate layer 101 by the substrate insulating layer 121. The through-via TH may have bent portions corresponding to the first to fourth channel portions CH1, CH2, CH3 and CH4 (see FIG. 2C) of the channel structures CH. However, in some example embodiments, the through-via TH may not have the bent portions, and may extend at a constant inclination from an upper end to a lower end.

The first and second horizontal conductive layers 102 and 104 may be sequentially stacked and disposed on an upper surface of the plate layer 101 in the first region R1. The first and second horizontal conductive layers 102 and 104 may be included in a common source structure together with the plate layer 101, and may function as a common source line for the semiconductor device 100f. The first horizontal conductive layer 102 may be directly connected to the channel layer 140 in lower portions of the channel structures CH.

The first and second horizontal conductive layers 102 and 104 may include a semiconductor material, and may include, for example, polycrystalline silicon. In this case, at least the first horizontal conductive layer 102 may be a layer doped with impurities of the same conductivity type as the plate layer 101. The second horizontal conductive layer 104 may be a doped layer, or may be a layer including impurities diffused from the first horizontal conductive layer 102.

The horizontal insulating layer 110 may be disposed on the plate layer 101 on the same level as the first horizontal conductive layer 102 in at least portions of the second to fourth regions R2, R3 and R4. The horizontal insulating layer 110 may include first and second horizontal insulating layers alternately stacked on the plate layer 101. The horizontal insulating layer 110 may be layers remaining after replacing a portion of the horizontal insulating layer 110 with the first horizontal conductive layer 102 during a manufacturing process of the semiconductor device 100f.

The horizontal insulating layer 110 may include silicon oxide, silicon nitride, silicon carbide, or silicon oxynitride. The first horizontal insulating layers and the second horizontal insulating layers may include different insulating materials.

The substrate insulating layer 121 may be disposed to penetrate through the plate layer 101, the horizontal insulating layer 110, and the second horizontal conductive layer 104 in the fourth region R4. The substrate insulating layer 121 may include an insulating material, for example, silicon oxide, silicon nitride, silicon carbide, or silicon oxynitride.

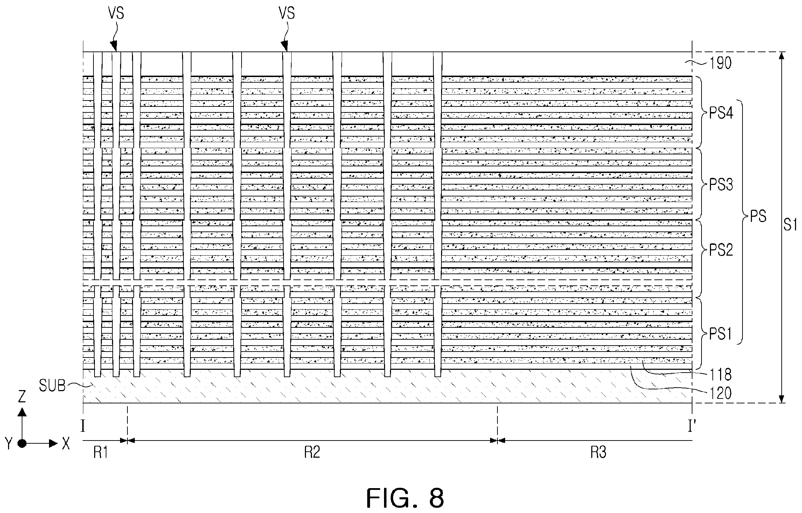

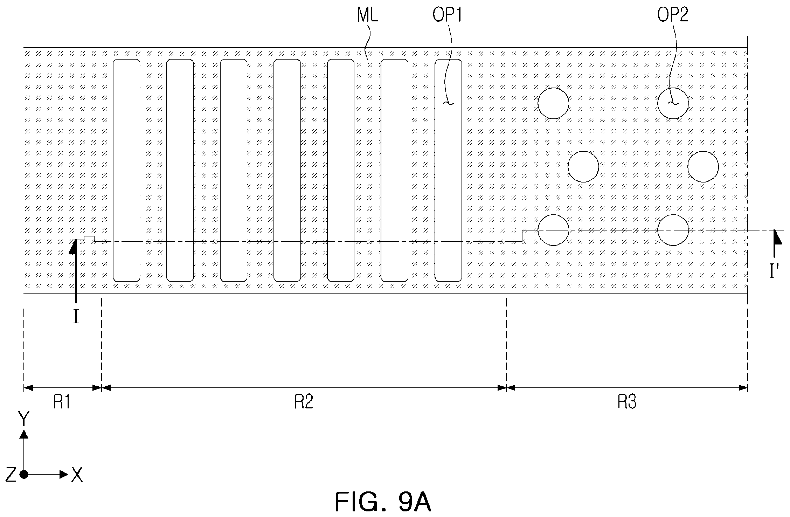

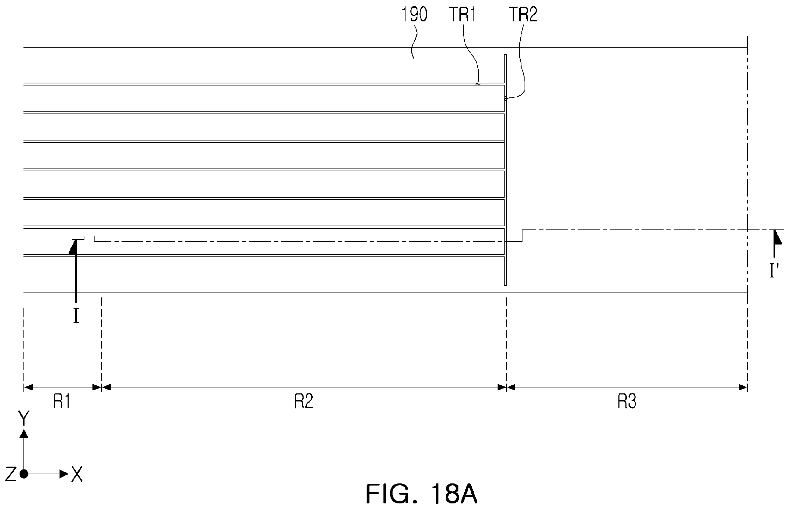

FIGS. 8, 9A, 9B, 10 to 17, 18A, 18B, and 19 to 21 are schematic plan views and cross-sectional views illustrating a method of manufacturing a semiconductor device according to example embodiments. In particular, FIGS. 9A and 18A illustrate a plane corresponding to FIG. 1, and each of FIGS. 8, 9B, 10 to 17, 18B, and 19 to 21 illustrates cross-sectional images corresponding to FIG. 2A.

Referring to FIG. 8, a manufacturing process of a first semiconductor structure S1 may begin. Sacrificial insulating layers 118 and interlayer insulating layers 120 may be alternately stacked on a base substrate SUB, and thus, a mold structure PS and vertical sacrificial structures VS penetrating therethrough may be formed, and a portion of a cell region insulating layer 190 may be formed.

The base substrate SUB is a layer removed through a subsequent process and may be a semiconductor substrate such as a silicon (Si) wafer. After a first mold stack structure PS1 of the mold structure PS is first formed and portions of the vertical sacrificial structures VS penetrating through are formed, a second mold stack structure PS2 may be formed and portions of the vertical sacrificial structures VS penetrating therethrough may be formed. Third and fourth mold stack structures PS3 and PS4 and portions of the vertical sacrificial structures VS may be formed in the same manner.

The sacrificial insulating layers 118 may be a layer replaced with the gate electrodes 130 (see FIG. 2A) through a subsequent process. The sacrificial insulating layers 118 may be formed of a material different from interlayer insulating layers 120, and may be formed of a material that may be etched with etch selectivity under specific etching conditions for the interlayer insulating layers 120. For example, the interlayer insulating layer 120 may be formed of at least one of silicon oxide or silicon nitride, and the sacrificial insulating layers 118 may be formed of a material different from the interlayer insulating layer 120 selected from silicon, silicon oxide, silicon carbide, and silicon nitride. In example embodiments, thicknesses of the interlayer insulating layers 120 may not all be identical to each other. The thicknesses of the interlayer insulating layers 120 and the sacrificial insulating layers 118 and the number of layers thereof may be variously changed from those illustrated.

Vertical sacrificial structures VS may be formed in positions corresponding to the channel structures CH, the first and second dummy vertical structures DH1 and DH2, and the gate separation regions MS of FIG. 2A. For example, the vertical sacrificial structures VS may be formed to have the same size as the channel structures CH. The vertical sacrificial structures VS may include, for example, carbon (C), but the present disclosure is not limited thereto.

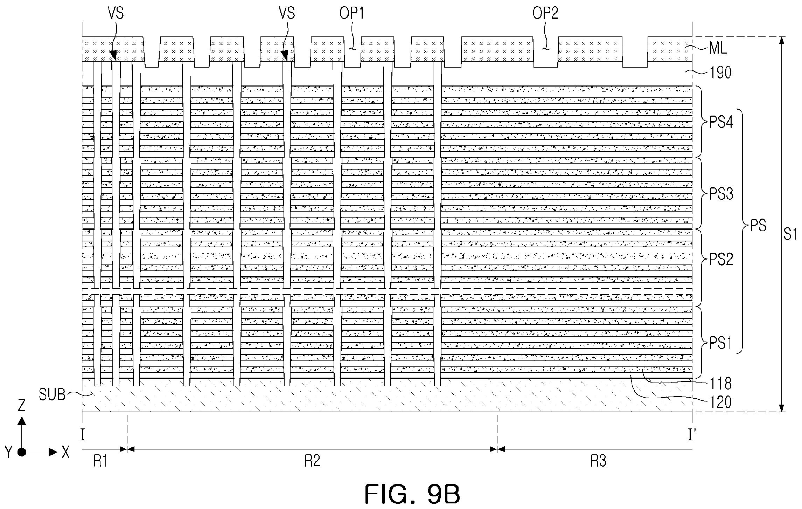

Referring to FIGS. 9A and 9B, a mask layer ML having first and second openings OP1 and OP2 may be formed on the cell region insulating layer 190.

The mask layer ML may include a hard mask layer and a photoresist layer. The hard mask layer may include, for example, polycrystalline silicon. The first openings OP1 may be formed to have a trench shape extending in the Y-direction in regions corresponding to the first contact plugs MC1 of FIG. 2A. The second openings OP2 may be formed to have a circular shape, an oval shape, or shapes similar thereto in regions corresponding to the second contact plugs MC2 of FIG. 2A. When patterning the mask layer ML, portions of the cell region insulating layer 190 therebelow may be removed, but the present disclosure is not limited thereto.

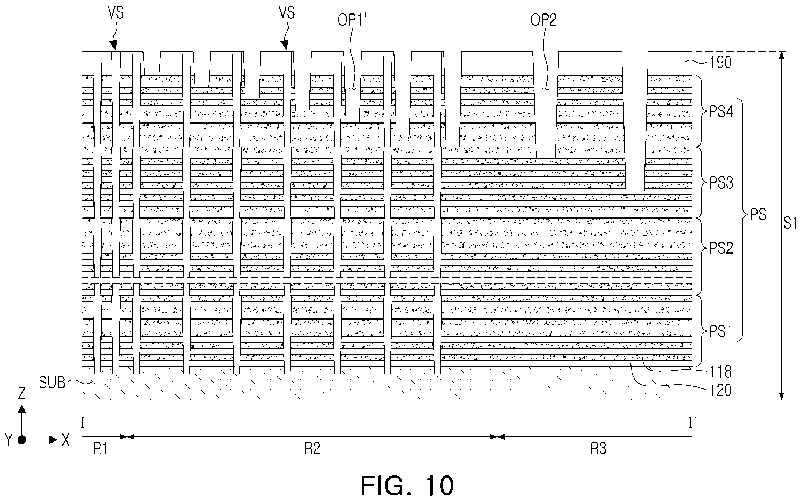

Referring to FIG. 10, the mold structure PS may be etched using the mask layer ML to form first and second contact openings OP1' and OP2' and the mask layer ML may be removed.

The first and second contact openings OP1' and OP2' may be formed to extend from the first and second openings OP1 and OP2 of the mask layer ML, respectively. The first and second contact openings OP1' and OP2' may be formed by repeatedly performing a plurality of etching processes of etching the mold structure PS by a predetermined depth. In FIG. 10, the sacrificial insulating layers 118 are illustrated as being exposed through bottom surfaces of the first and second contact openings OP1' and OP2', but the present disclosure is not limited thereto, and portions of the upper interlayer insulating layers 120 may remain on the sacrificial insulating layers 118, respectively.

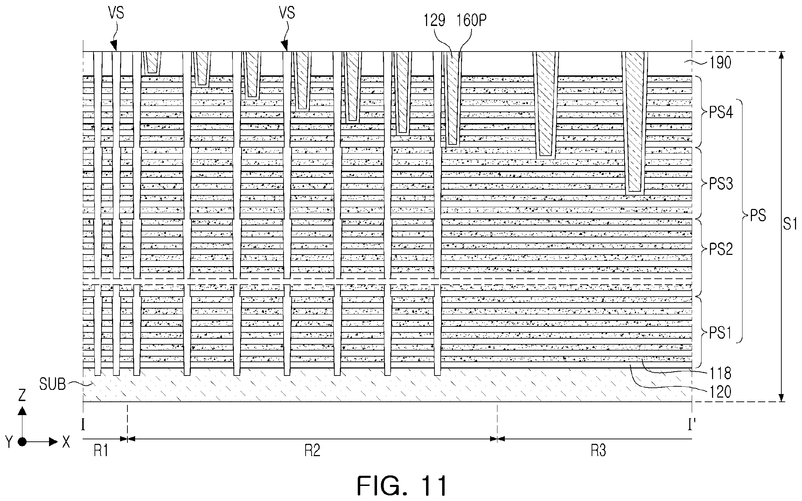

Referring to FIG. 11, preliminary contact insulating layers 160P and contact sacrificial layers 129 may be formed in the first and second contact openings OP1' and OP2'.

The preliminary contact insulating layers 160P may be conformally formed to be on (e.g., to cover) sidewalls and bottom surfaces of the first and second contact openings OP1' and OP2'. For example, the preliminary contact insulating layers 160P may be formed using an atomic layer deposition (ALD) or a chemical vapor deposition (CVD) process.

The contact sacrificial layers 129 may be formed to be in (e.g., to fill) the first and second contact openings OP1' and OP2' on the preliminary contact insulating layers 160P. The contact sacrificial layers 129 may include a material different from that of the preliminary contact insulating layers 160P, and may include, for example, carbon (C).

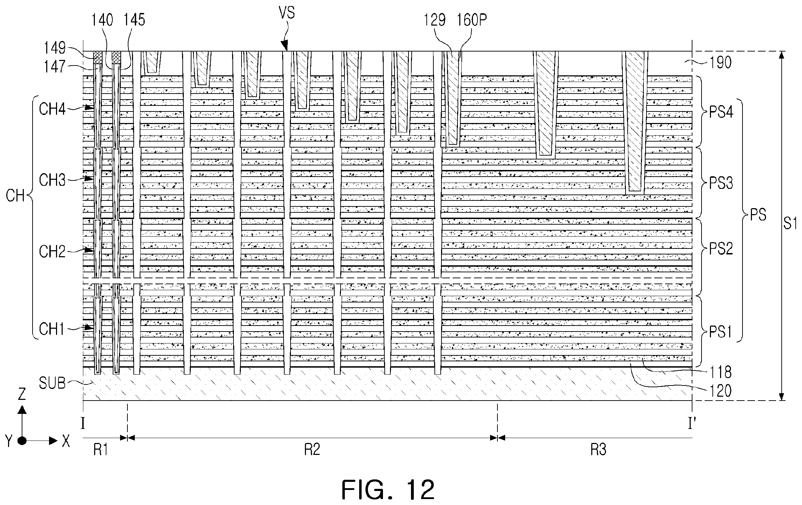

Referring to FIG. 12, portions of the vertical sacrificial structures VS may be removed and channel structures CH may be formed.

A mask layer exposing only regions corresponding to the channel structures CH in a first region R1 may be formed, and the exposed vertical sacrificial structures VS may be removed to form channel holes. Channel structures CH may be formed by sequentially depositing at least a portion of a channel dielectric layer 145, a channel layer 140, a channel buried insulating layer 147, and a channel pad 149 in the channel holes.

The channel dielectric layer 145 may be formed to have a uniform thickness using the ALD process or the CVD process. In this operation, the channel dielectric layer 145 may be formed in whole or in part, and a portion extending to be perpendicular to a plate layer 101 (see FIG. 2A) along the channel structures CH may be formed in this operation. The channel layer 140 may be formed on the channel dielectric layer 145 in the channel holes. The channel buried insulating layer 147 may be formed to be in (e.g., to fill) the channel holes, and may be formed of an insulating material. The channel pad 149 may be formed of a conductive material, and may be formed of, for example, polycrystalline silicon.

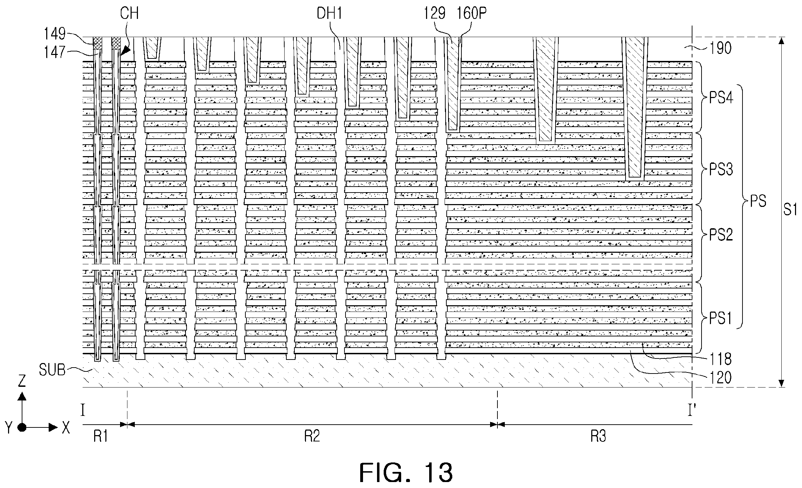

Referring to FIG. 13, portions of the vertical sacrificial structures VS may be removed and first and second dummy vertical structures DH1 and DH2 may be formed.

A mask layer exposing regions corresponding to the first and second dummy vertical structures DH1 and DH2 in second and third regions R2 and R3 may be formed, and the exposed vertical sacrificial structures VS may be removed to form dummy holes. A process of expanding the dummy holes may be performed by removing a portion of the mold structure PS around the dummy holes. The expanded dummy holes may be filled with an insulating material to form the first and second dummy vertical structures DH1 and DH2.

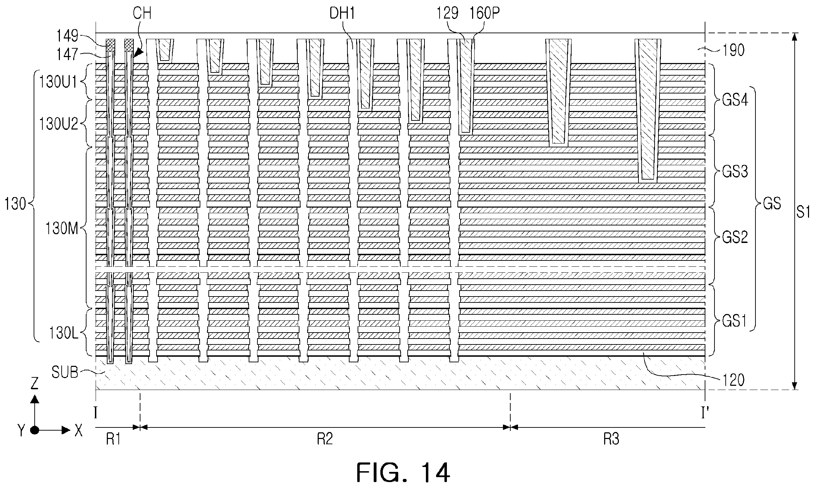

Referring to FIG. 14, the sacrificial insulating layers 118 may be removed and gate electrodes 130 may be formed.

After further forming a portion of the cell region insulating layer 190, vertical holes may be formed by removing the vertical sacrificial structures VS in positions corresponding to the gate separation regions MS of FIG. 1. A portion of the mold structure PS may be removed around the vertical holes so that the vertical holes are expanded to be connected to each other, thereby forming trench-shaped openings corresponding to the gate separation regions MS.

The sacrificial insulating layers 118 exposed through the openings may be removed. The sacrificial insulating layers 118 may be selectively removed without removing the interlayer insulating layers 120, the channel structures CH, the first and second dummy vertical structures DH1 and DH2, and the preliminary contact insulating layers 160P, for example, using wet etching.

The gate electrodes 130 may be formed by depositing a conductive material in regions from which the sacrificial insulating layers 118 are removed. The conductive material may include a metal, polycrystalline silicon, or a metal silicide material. In the gate electrodes 130, after forming the gate barrier layers 132 (see FIG. 3A), the gate conductive layers 135 (see FIG. 3A) may be formed. In some example embodiments, a portion of the channel dielectric layer 145 (see FIG. 3C) may first be formed prior to forming the gate electrodes 130. Accordingly, a gate structure GS including first to fourth stack structures GS1, GS2, GS3 and GS4 may be formed. After forming the gate electrodes 130, gate separation regions MS may be formed by depositing an insulating material in the openings.

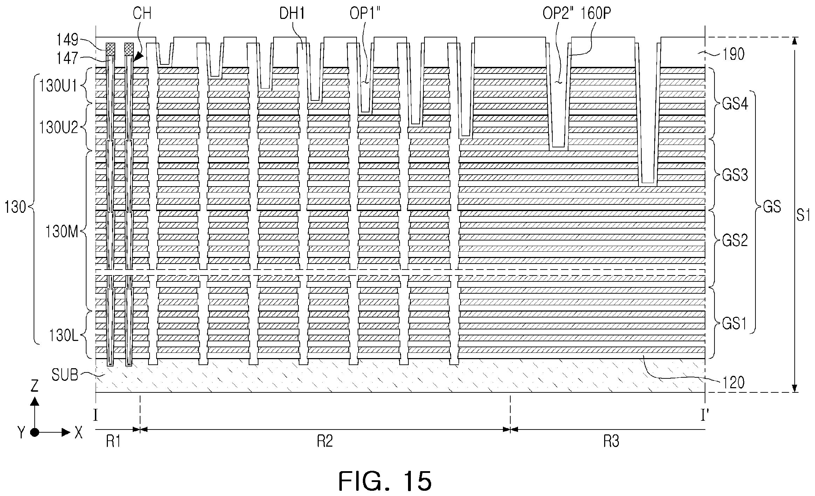

Referring to FIG. 15, the contact sacrificial layers 129 may be removed to form first and second contact openings OP1" and OP2".

After removing a portion of the cell region insulating layer 190 on the contact sacrificial layers 129 to expose the contact sacrificial layers 129, the exposed contact sacrificial layers 129 may be selectively removed with respect to preliminary contact insulating layers 160P.

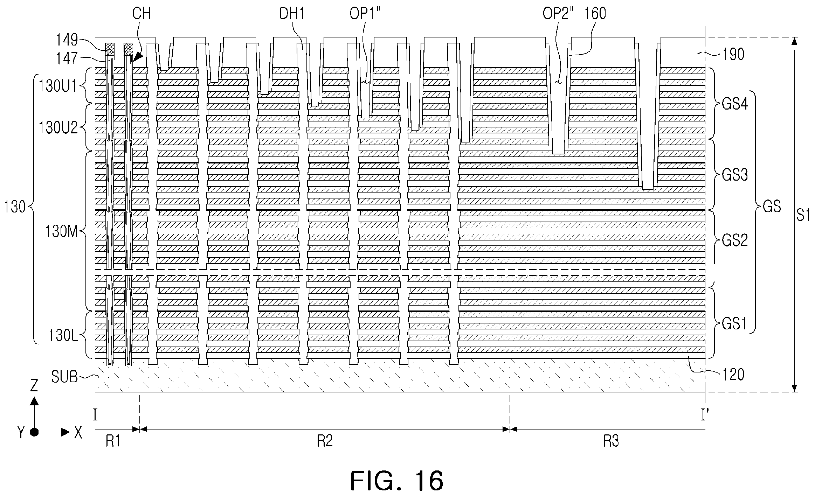

Referring to FIG. 16, contact insulating layers 160 may be formed by removing a portion of the preliminary contact insulating layers 160P.

The preliminary contact insulating layers 160P exposed through the first and second contact openings OP1" and OP2" may be partially removed on bottom surfaces of the first and second contact openings OP1" and OP2". To this end, additional spacer layers may be formed on sidewalls of the first and second contact openings OP1" and OP2", but the present disclosure is not limited thereto. Upon removal of the preliminary contact insulating layers 160P, the exposed gate electrodes 130 may also be partially recessed from upper surfaces thereof. Accordingly, contact insulating layers 160 disposed only on the sidewalls of the first and second contact openings OP1" and OP2" may be formed.

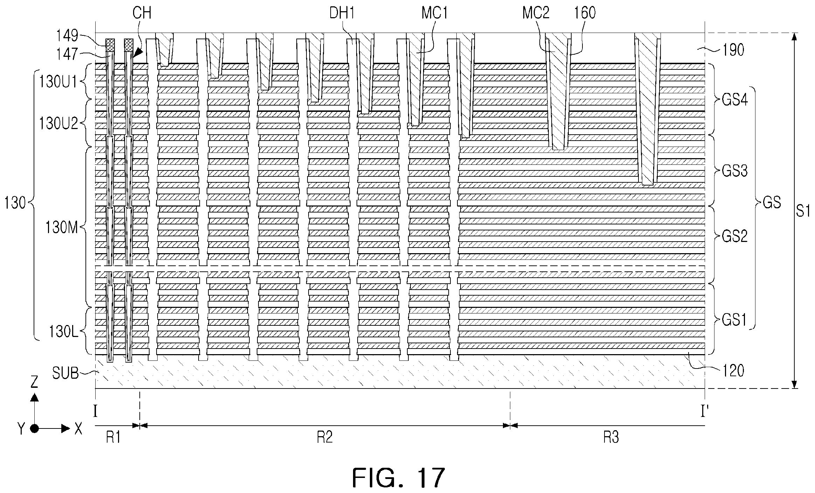

Referring to FIG. 17, first and second contact plugs MC1 and MC2 may be formed by depositing a conductive material in the first and second contact openings OP1" and OP2".

The first and second contact plugs MC1 and MC2 may be formed together by depositing a conductive material in the first and second contact openings OP1" and OP2". The first and second contact plugs MC1 and MC2 may be physically connected to the gate electrodes 130.

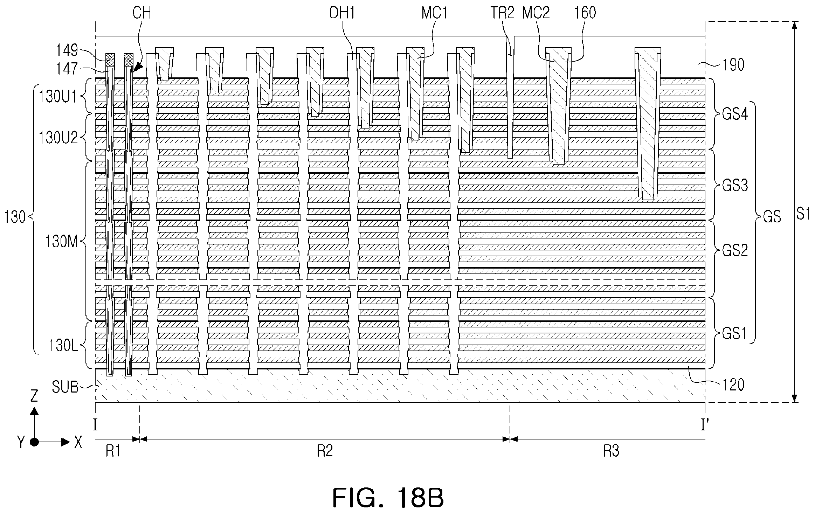

Referring to FIGS. 18A and 18B, first and second trenches TR1 and TR2 penetrating through the first and second upper gate electrodes 130U1 and 130U2 may be formed.

The first and second trenches TR1 and TR2 may be formed by removing a portion of the gate structure GS so as to penetrate through the first and second upper gate electrodes 130U1 and 130U2, in regions corresponding to the first and second upper separation regions SS1 and SS2 of FIG. 1, respectively. The first and second trenches TR1 and TR2 may be formed to extend while cutting portions of the channel structures CH in the first region R1.

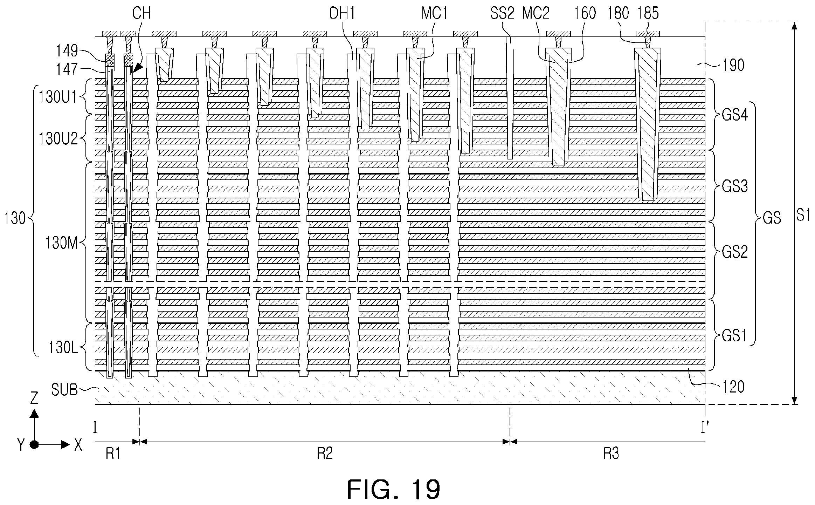

Referring to FIG. 19, first and second upper separation regions SS1 and SS2 may be formed by depositing an insulating material on (e.g., in) the first and second trenches TR1 and TR2, and studs 180 and cell interconnection lines 185 may be formed.

The first and second upper separation regions SS1 and SS2 may be formed by filling the first and second trenches TR1 and TR2 with the insulating material and performing a planarization process.

The studs 180 may be formed by penetrating through the cell region insulating layer 190 to form stud holes exposing the channel structures CH and the first and second contact plugs MC1 and MC2, and then filling the stud holes with a conductive material. The cell interconnection lines 185 may be formed on the studs 180.

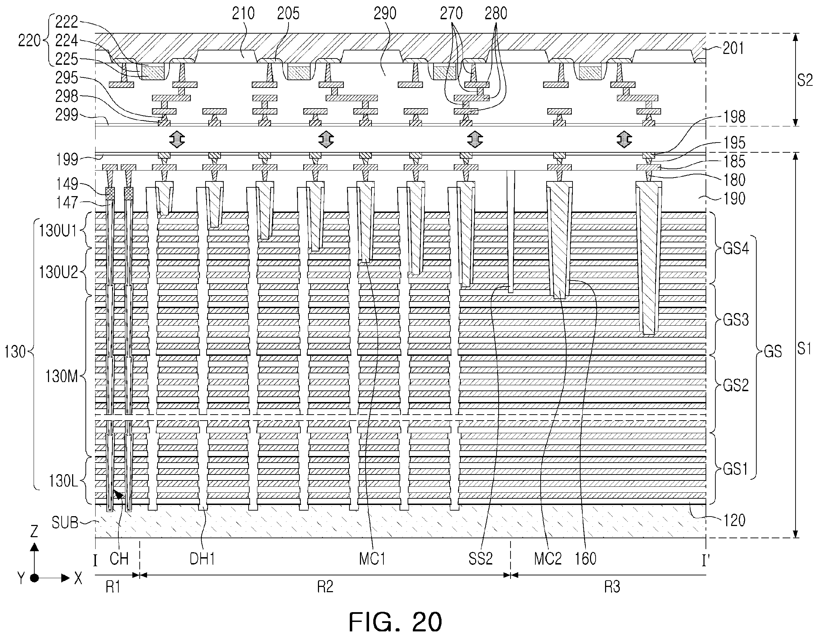

Referring to FIG. 20, a first bonding structure may be formed to form a first semiconductor structure S1, and a second semiconductor structure S2 may be formed, and then, the first semiconductor structure S1 and the second semiconductor structure S2 may be bonded.

First bonding vias 195 and first bonding metal layers 198 included in the first bonding structure may be formed by further forming the cell region insulating layer 190 on the cell interconnection lines 185 and forming the first bonding insulating layer 199, and then removing portions of these layers and depositing the conductive material in the removed portions. Upper surfaces of the first bonding metal layers 198 may be exposed from the cell region insulating layer 190. Accordingly, the first semiconductor structure S1 may be prepared.

The second semiconductor structure S2 may be prepared by forming circuit elements 220, circuit interconnection structures, and a second bonding structure on the substrate 201.

Device isolating layers 210 may be formed in the substrate 201, and a circuit gate dielectric layer 222 and a circuit gate electrode 225 may be sequentially formed on the substrate 201. The device isolating layers 210 may be formed in, for example, a shallow trench isolation (STI) process. The circuit gate dielectric layer 222 and the circuit gate electrode 225 may be formed using the ALD process or the CVD process. The circuit gate dielectric layer 222 may be formed of silicon oxide, and the circuit gate electrode 225 may be formed of at least one of polycrystalline silicon or a metal silicide layer, but the present disclosure is not limited thereto. A spacer layer 224 and source/drain regions 205 may be formed on both (i.e., opposite) sidewalls of the circuit gate dielectric layer 222 and the circuit gate electrode 225. According to example embodiments, the spacer layer 224 may be comprised of a plurality of layers. The source/drain regions 205 may be formed by performing an ion implantation process.

The circuit contact plugs 270 of the circuit interconnection structure and the second bonding vias 295 of the second bonding structure may be formed by partially forming a peripheral region insulating layer 290, and then partially etching and removing the peripheral region insulating layer 290 and filling the removed portion with the conductive material. The circuit interconnection lines 280 of the circuit interconnection structure and the second bonding metal layers 298 of the second bonding structure may be formed, for example, by depositing the conductive material and then patterning the conductive material. The second bonding metal layers 298 may be formed so that lower surfaces thereof are exposed through the second bonding insulating layer 299.

The peripheral region insulating layer 290 may be comprised of a plurality of insulating layers. The peripheral region insulating layer 290 may be partially formed in each operation of forming the circuit interconnection structure and the second bonding structure. Through this operation, the second semiconductor structure S2 may be prepared.

The first semiconductor structure S1 and the second semiconductor structure S2 may be connected to each other by bonding the first bonding metal layers 198 and the second bonding metal layers 298 by applying pressure. At the same time, the first bonding insulating layers 199 and the second bonding insulating layers 299 may also be bonded by pressure. The second semiconductor structure S2 on the first semiconductor structure S1 may be turned over so that the second bonding metal layers 298 face downwardly, and then bonding may be performed. The bonding may be performed by attaching an additional carrier substrate to one surface of the second semiconductor structure S2, for example, to one surface of the substrate 201.

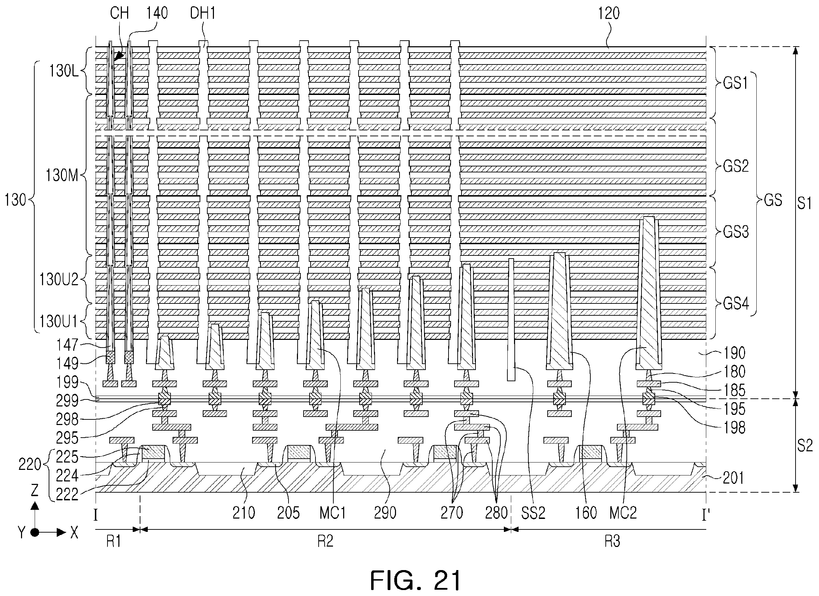

Referring to FIG. 21, the base substrate SUB may be removed and the channel layers 140 may be exposed.

In the bonding structure of the first semiconductor structure S1 and the second semiconductor structure S2, the channel layers 140 may be exposed by removing the base substrate SUB and removing portions of the exposed channel dielectric layers 145 (see FIG. 3C).

Next, referring back to FIG. 2A, the semiconductor device 100 may be manufactured by forming the plate layer 101 connected to the channel layers 140. In some example embodiments, the plate layer 101 may be formed as a conformal layer along upper ends of the channel structures CH and upper ends of the first and second dummy vertical structures DH1 and DH2.

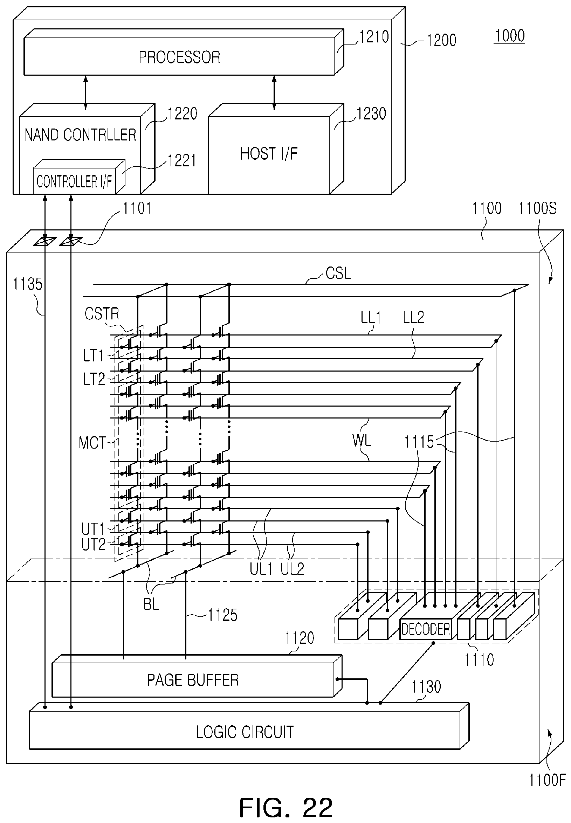

FIG. 22 is a view schematically illustrating a data storage system including a semiconductor device according to example embodiments.

Referring to FIG. 22, a data storage system 1000 may include a semiconductor device 1100 (which may also be referred to as a semiconductor storage device 1100) and a controller 1200 electrically connected to the semiconductor device 1100. The data storage system 1000 may be a storage device including one or a plurality of semiconductor devices 1100 or an electronic device including a storage device. For example, the data storage system 1000 may be a solid state drive (SSD) device, a universal serial bus (USB), a computing system, a medical device, or a communication device, including one or more semiconductor devices 1100.

The semiconductor device 1100 may be a non-volatile memory device, for example, the NAND flash memory device described above with reference to FIGS. 1 to 7. The semiconductor device 1100 may include a first structure 1100F and a second structure 1100S on the first structure 1100F. In example embodiments, the first structure 1100F may be disposed next to the second structure 1100S. The first structure 1100F may be a peripheral circuit structure including a decoder circuit 1110, a page buffer 1120, and a logic circuit 1130. The second structure 1100S may be a memory cell structure including a bit line BL, a common source line CSL, word lines WL, first and second gate upper lines UL1 and UL2, first and second gate lower lines LL1 and LL2, and memory cell strings CSTR between the bit line BL and the common source line CSL.

In the second structure 1100S, each of the memory cell strings CSTR may include lower transistors LT1 and LT2 adjacent to the common source line CSL, upper transistors UT1 and UT2 adjacent to the bit line BL, and a plurality of memory cell transistors MCT disposed between the lower transistors LT1 and LT2 and the upper transistors UT1 and UT2. The number of lower transistors LT1 and LT2 and the number of upper transistors UT1 and UT2 may be variously changed according to example embodiments.

In example embodiments, the upper transistors UT1 and UT2 may include a string select transistor, and the lower transistors LT1 and LT2 may include a ground select transistor. The gate lower lines LL1 and LL2 may be gate electrodes of the lower transistors LT1 and LT2, respectively. The word lines WL may be gate electrodes of the memory cell transistors MCT, and the gate upper lines UL1 and UL2 may be gate electrodes of the upper transistors UT1 and UT2, respectively.

In example embodiments, the lower transistors LT1 and LT2 may include a lower erase control transistor LT1 and a ground select transistor LT2 connected in series. The upper transistors UT1 and UT2 may include a string select transistor UT1 and an upper erase control transistor UT2 connected in series. At least one of the lower erase control transistor LT1 and the upper erase control transistor UT2 may be used in an erase operation of deleting data stored in the memory cell transistors MCT using a gate-induced drain leakage (GIDL) phenomenon.

The common source line CSL, the first and second gate lower lines LL1 and LL2, the word lines WL, and the first and second gate upper lines UL1 and UL2 may be electrically connected to the decoder circuit 1110 through first connection interconnection lines 1115 extending from the first structure 1100F to the second structure 1100S. The bit lines BL may be electrically connected to the page buffer 1120 through second connection interconnection lines 1125 extending from the first structure 1100F to the second structure 1100S.

In the first structure 1100F, the decoder circuit 1110 and the page buffer 1120 may perform a control operation on at least one selected memory cell transistor among the plurality of memory cell transistors MCT. The decoder circuit 1110 and the page buffer 1120 may be controlled by the logic circuit 1130. The semiconductor device 1100 may communicate with the controller 1200 through an input/output pad 1101 electrically connected to the logic circuit 1130. The input/output pad 1101 may be electrically connected to the logic circuit 1130 through an input/output connection interconnection line 1135 extending from the first structure 1100F to the second structure 1100S.

The controller 1200 may include a processor 1210, a NAND controller 1220, and a host interface 1230. According to example embodiments, the data storage system 1000 may include a plurality of semiconductor devices 1100, and in this case, the controller 1200 may control a plurality of semiconductor devices 1100.

The processor 1210 may control an overall operation of the data storage system 1000, including the controller 1200. The processor 1210 may operate according to predetermined firmware, and the semiconductor device 1100 may be accessed by controlling the NAND controller 1220. The NAND controller 1220 may include a NAND interface 1221 processing communication with the semiconductor device 1100. Through the NAND interface 1221, control commands for controlling the semiconductor device 1100, data to be recorded in the memory cell transistors MCT of the semiconductor device 1100, and data to be read from the memory cell transistors MCT of the semiconductor device 1100 may be transmitted. The host interface 1230 may provide a communication function between the data storage system 1000 and an external host. When receiving a control command from an external host through the host interface 1230, the processor 1210 may control the semiconductor device 1100 in response to control commands.

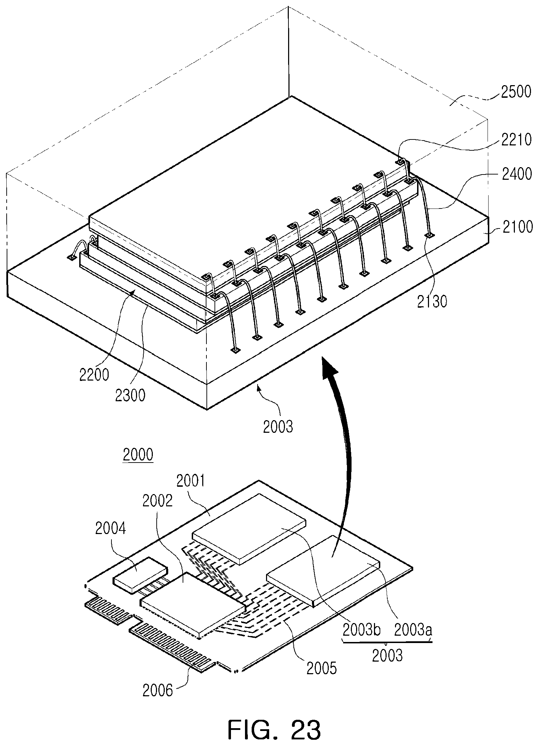

FIG. 23 is a perspective view schematically illustrating a data storage system including a semiconductor device according to example embodiments.

Referring to FIG. 23, a data storage system 2000 may include a main board 2001, a controller 2002 mounted on the main board 2001, one or more semiconductor packages 2003, and DRAM 2004. The semiconductor package 2003 and the DRAM 2004 may be connected to the controller 2002 through interconnection patterns 2005 formed on the main board 2001.

The main board 2001 may include a connector 2006 including a plurality of pins coupled to an external host. The number and arrangement of the plurality of pins in the connector 2006 may vary, depending on a communication interface between the data storage system 2000 and the external host. In example embodiments, the data storage system 2000 may communicate with an external host according to any one of the interfaces, for example, universal serial bus (USB), peripheral component interconnect express (PCI-Express), serial advanced technology attachment (SATA), and M-Phy for universal flash storage (UFS). In example embodiments, the data storage system 2000 may operate with power supplied through the connector 2006 from the external host. The data storage system 2000 may further include a power management integrated circuit (PMIC) that distributes power supplied from the external host to the controller 2002 and the semiconductor package 2003.

The controller 2002 may record data in the semiconductor package 2003, may read data from the semiconductor package 2003, or may improve an operating speed of the data storage system 2000.

The DRAM 2004 may be a buffer memory that reduces a difference in speed between the semiconductor package 2003 that serves as a data storage space, and the external host. The DRAM 2004 included in the data storage system 2000 may also operate as a type of cache memory, and may provide space for temporarily storing data in a control operation for the semiconductor package 2003. When the data storage system 2000 includes the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b spaced apart from each other. Each of the first and second semiconductor packages 2003a and 2003b may be a semiconductor package including a plurality of semiconductor chips 2200. Each of the first and second semiconductor packages 2003a and 2003b may include a package substrate 2100, semiconductor chips 2200 on the package substrate 2100, adhesive layers 2300 disposed on lower surfaces of each of the semiconductor chips 2200, a connection structure 2400 electrically connecting the semiconductor chips 2200 and the package substrate 2100, and a molding layer 2500 on (e.g., covering) the semiconductor chips 2200 and the connection structure 2400 on the package substrate 2100.

The package substrate 2100 may be a printed circuit board (PCB) including package upper pads 2130. Each semiconductor chip 2200 may include an input/output pad 2210. The input/output pad 2210 may correspond to the input/output pad 1101 of FIG. 22. Each of the semiconductor chips 2200 may include at least one of the semiconductor devices described above with reference to FIGS. 1 to 7.

In example embodiments, the connection structure 2400 may be a bonding wire electrically connecting the input/output pad 2210 and the package upper pads 2130. Accordingly, in each of the first and second semiconductor packages 2003a and 2003b, the semiconductor chips 2200 may be electrically connected to each other using a bonding wire manner, or may be electrically connected to the package upper pads 2130 of the package substrate 2100. According to other example embodiments, in each of the first and second semiconductor packages 2003a and 2003b, the semiconductor chips 2200 may be electrically connected to each other by a connection structure including a Through-Silicon Via (TSV) instead of the connection structure 2400 having a bonding wire manner.

In example embodiments, the controller 2002 and the semiconductor chips 2200 may be included in a single package. In some example embodiments, a controller 2002 and semiconductor chips 2200 may be mounted on a separate interposer substrate other than the main board 2001, and the controller 2002 and the semiconductor chips 2200 may be connected to each other through interconnection lines formed on the interposer substrate.

As used herein, the terms "comprises", "comprising", "includes", "including", "has", "having" and any other variations thereof specify the presence of the stated features, steps, operations, elements, components, and/or groups but do not preclude the presence or addition of one or more other features, steps, operations, elements, components, and/or groups thereof. In addition, it will be understood that, although the terms "first", "second", "third", etc. may be used herein to describe various elements, these elements should not be limited by these terms. Rather, these terms are only used to distinguish one element from another. For example, a first element could be termed a second element, and, similarly, a second element could be termed a first element.

## Claims

1. A semiconductor device (100), comprising:
a plate layer (101);
gate electrodes (130) stacked and spaced apart from each other in a first direction (Z) perpendicular to an upper surface of the plate layer (101), in first to third regions (R1-R3), and including lower gate electrodes (130L), memory gate electrodes (130M), and upper gate electrodes (130U) sequentially stacked on the plate layer (101);
channel structures (CH) in the first region (R1) and extending through the gate electrodes (130) in the first direction (Z);
first contact plugs (MC1) extending into at least one of the upper gate electrodes (130U) and electrically connected to the upper gate electrodes (130U), respectively, in the second region (R2);
second contact plugs (MC2) extending through a portion of the gate electrodes (130) including the upper gate electrodes (130U) and electrically connected to the memory gate electrodes (130M) and the lower gate electrodes (130L), respectively, in the third region (R3);
gate separation regions (MS) extending through the gate electrodes (130), extending in a second direction (X) perpendicular to the first direction (Z) in the first to third regions (R1-R3), and spaced apart from each other in a third direction (Y) perpendicular to the first and second directions (X);
first upper separation regions (SS1) extending through the upper gate electrodes (130U) between the gate separation regions (MS), and extending in the second direction (X) in the first and second regions (R1, R2); and
a second upper separation region (SS2) connected to ends of the first upper separation regions (SS1), extending through the upper gate electrodes (130U), and extending in the third direction (Y) along a boundary between the second region (R2) and the third region (R3),
wherein the first contact plugs (MC1) are arranged in a shape of at least one line, with the first upper separation regions (SS1) between ones of the first contact plugs (MC1) in the third direction (Y), and
wherein each of the first contact plugs (MC1) is in contact with a side surface of at least one of the first upper separation regions (SS1) in the third direction (Y).

2. The semiconductor device (100) of claim 1, wherein at least one of the first contact plugs (MC1) is between adjacent ones of the first upper separation regions (SS1) in the third direction (Y) and is in contact with the adjacent ones of the first upper separation regions (SS1).

3. The semiconductor device (100) of claim 1 or 2, wherein the first contact plugs (MC1) are arranged in at least one column in the third direction (Y), and
wherein a number of the first contact plugs (MC1) in the at least one column is one more than a number of the first upper separation regions (SS1) between an adjacent pair of the gate separation regions (MS) in the third direction (Y).

4. The semiconductor device (100) of any one of claims 1 to 3, wherein each of the first contact plugs (MC1) includes a contact barrier layer (172) and a contact conductive layer (175) on the contact barrier layer (172), and
wherein the contact conductive layer (175) of a respective one of the first contact plugs (MC1) is in contact with the side surface of the at least one of the first upper separation regions (SS1) in the third direction (Y).

5. The semiconductor device (100) of any one of claims 1 to 4, wherein the second contact plugs (MC2) have a different shape from the first contact plugs (MC1) in a plan view.

6. The semiconductor device (100) of any one of claims 1 to 5, wherein the second contact plugs (MC2) are spaced apart from each other with ones of the gate electrodes (130) therebetween.

7. The semiconductor device (100) of any one of claims 1 to 6, wherein widths of the second contact plugs (MC2) are greater than widths of the first contact plugs (MC1).

8. The semiconductor device (100) of any one of claims 1 to 7, wherein the first upper separation regions (SS1) extend into portions of the channel structures (CH).

9. The semiconductor device (100) of any one of claims 1 to 8, further comprising contact insulating layers on portions of side surfaces of each of the first contact plugs (MC1) and on a side surface of each of the second contact plugs (MC2).

10. The semiconductor device (100) of any one of claims 1 to 9, further comprising dummy vertical structures (DH) around the first and second contact plugs (MC2), and extending through the gate electrodes (130) in the first direction (Z) in the second and third regions (R2, R3).

11. The semiconductor device (100) of claim 10, wherein the dummy vertical structures (DH) in the second region (R2) are in contact with side surfaces of the first contact plugs (MC1) in the second direction (X), respectively.

12. The semiconductor device (100) of any one of claims 1 to 11, wherein ends of the gate electrodes (130) in the second direction (X) are outside the third region (R3).

13. A data storage system (1000, 2000), comprising:
a semiconductor storage device (1100) including a first semiconductor structure (S1) comprising circuit elements (220), a second semiconductor structure (S2) on the first semiconductor structure (S1) and comprising the semiconductor device (100) of any one of the preceding claims, and an input/output pad (1101, 2210) electrically connected to the circuit elements (220); and
a controller (1200, 1220, 2002) electrically connected to the semiconductor storage device (1100) through the input/output pad (1101, 2210) and configured to control the semiconductor storage device (1100).
